# EUROPEAN PATENT APPLICATION

(11) **EP 1 158 586 A1**
(43) Date of publication of application: **28.11.2001**
(21) Application number: 00903979.3
(22) Date of filing: 16.02.2000
(51) Int. Cl.: H01L 41/107

(54) **PIEZOELECTRIC TRANSFORMER**

(30) Priority: 16.02.1999 JP 3705699; 10.03.1999 JP 6327799; 31.03.1999 JP 9368099; 28.04.1999 JP 12184299
(71) Applicant: Mitsui Chemicals, Inc., Tokyo 100-6070 (JP)
(72) Inventor: YOSHIDA, Mitsunobu Mitsui Chemicals, Inc., Sodegaura-shi Chiba 299-0265 (JP); KANAYAMA, Kouichi Mitsui Chemicals, Inc., Sodegaura-shi Chiba 299-0265 (JP)
(74) Representative: HOFFMANN - EITLE
(86) International application number: JP0000866
(87) International publication number: WO0049667

(57) **Abstract**

A piezoelectric transformer comprises at least two flat piezoelectric substrates (1, 2, 3) each having opposite major surfaces provided with electrodes, and the piezoelectric substrates are joined with at least two spacers (4a, 4b, 4c, 4d) interposed between them. The first piezoelectric substrate (1) and the second piezoelectric substrate (2) are arranged with a space created by at least two spacers (4a, 4b) between them in such a manner that the lower side of the first piezoelectric substrate (1) is opposed to the upper side of the second piezoelectric substrate (2). An input section is provided on one of the two piezoelectric substrates (1, 2), and an output section is provided on the other piezoelectric substrate. This piezoelectric transformer can provide high power output.

## Description

### TECHNICAL FIELD

The present invention relates to a piezoelectric transformer, and more particularly, to a piezoelectric transformer used in a power converter, such as a liquid crystal backlight inverter or a DC-DC converter.

### BACKGROUND ART

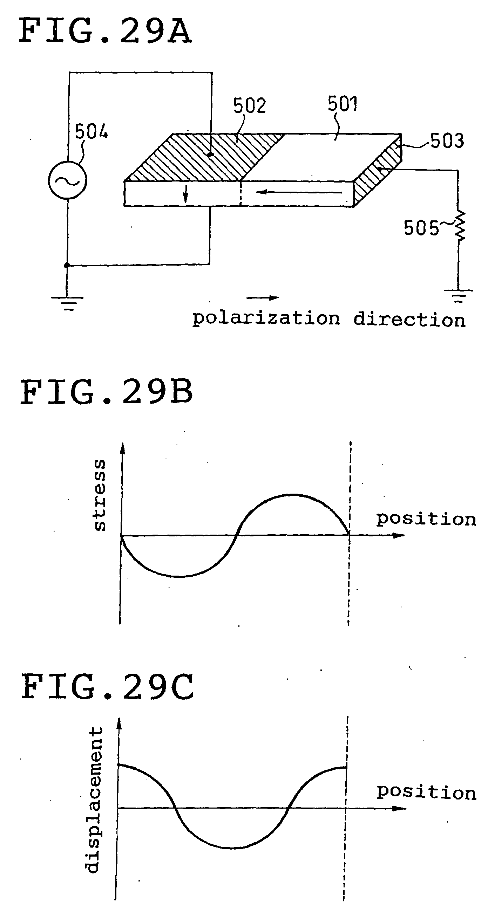

Compared to electromagnetic transformers, piezoelectric transformers have advantageous characteristics of, for example, high efficiency, miniaturization, incombustibility, and low noise. In recent years, making use of the advantageous characteristics, the piezoelectric transformers are used in liquid crystal display backlight inverters of notebook type personal computers as high voltage outputting transformers. Hereinbelow, a basic configuration and principles of operation of a piezoelectric transformer will be described with reference to Figs.29A to 29C. Fig.29A is a perspective view of a Rosen type piezoelectric transformer. In the figure, a pair of input electrodes 502 are provided on upper and lower surfaces of the left half of a rectangular parallelepiped piezoelectric ceramic substrate 501, and the region between the input electrodes is polarized perpendicular to the upper and lower surfaces. An output electrode 503 is provided on an end face in the right half, and the polarization direction in the right half region is polarized in the longitudinal direction. The input electrodes are connected to a power supply 504, and the output electrode is connected to a load 505. Upon application of voltage from the power supply, an electric field is applied in the thickness direction to the left half portion shown in the figure, longitudinal vibrations in the longitudinal direction are caused due to a piezoelectric transverse effect that causes displacement in perpendicular to the polarization direction. Thereby, the overall piezoelectric transformer vibrates. In addition, in the right half portion, mechanical distortion occurs in the longitudinal direction. Then, according to a piezoelectric longitudinal effect, a voltage having the same frequency as that of the voltage applied between input electrodes can be obtained from the output electrode 503. When a driving voltage having a frequency near the resonant frequency of the piezoelectric transformer is applied between the input electrodes, a voltage higher than the input voltage can be obtained. In this case, according to resonance, stress is distributed as shown in Fig.29B, amplitude is distributed as shown in Fig.29C, and a longitudinal central portion of the piezoelectric ceramic substrate corresponds to a node of the vibration.

However, in the above Rosen type piezoelectric transformer, the output level is not sufficiently high, and a piezoelectric transformer capable of generating higher level outputs has been demanded.

Accordingly, a primary object of the present invention is to provide a high output generating piezoelectric transformer.

### DISCLOSURE OF THE INVENTION

According to a first aspect of the present invention, there is provided a piezoelectric transformer characterized in that at least two piezoelectric substrates connected via at least two connectors, each of the aforementioned at least two piezoelectric substrates being formed of a piezoelectric material, having a plane plate shape and including a first main face and a second main face opposing thereto,
the aforementioned at least two piezoelectric substrates include a first piezoelectric substrate and a second piezoelectric substrate;
the aforementioned first main face of one of the aforementioned first piezoelectric substrate and the aforementioned second piezoelectric substrate is disposed opposite to the aforementioned second main face of the other one of the aforementioned first piezoelectric substrate and the aforementioned second piezoelectric substrate;
the aforementioned at least two connectors and an air gap are provided between the aforementioned first main face of the aforementioned one of the piezoelectric substrates and the aforementioned second main face of the aforementioned other of the piezoelectric substrate; and
an input section is provided at the aforementioned one of the piezoelectric substrates, and an output section is provided at the aforementioned other of the piezoelectric substrates.

In the above piezoelectric transformer, it is preferable that
the aforementioned at least two connectors include a first connector, a second connector, and a third connector;
the aforementioned air gap is provided between the aforementioned first connector, the aforementioned second connector, and the aforementioned third connector;
each of the aforementioned first piezoelectric substrate and the aforementioned second piezoelectric substrate has a rectangular parallelepiped shape, and is divided into N equal regions (N is an integer which is equal to two or larger) in a longitudinal direction;
the aforementioned first connector and the aforementioned second connector are positioned at longitudinal end portions of the aforementioned piezoelectric substrates; and
the aforementioned third connector is positioned at a border of the aforementioned regions of each of the aforementioned first piezoelectric substrate and the aforementioned second piezoelectric substrate.

In addition, it is preferable that
electrodes are respectively provided on the aforementioned first main face and the aforementioned second main face of the first piezoelectric substrate, and the first piezoelectric substrate between the aforementioned electrodes is polarized in a direction perpendicular to the aforementioned first main face.

Furthermore, it is preferable that
the aforementioned first piezoelectric substrate have a structure in which a plurality of electrode layers and a plurality of piezoelectric material layers each formed of a piezoelectric material are alternately laminated, the aforementioned plurality of electrode layers are grouped into two electrode groups, and the aforementioned electrode layers within the same electrode group are electrically connected to each other.

Still furthermore, it is preferable that
electrodes are respectively provided at both ends in the aforementioned longitudinal direction and at the border between the aforementioned regions of at least one of the aforementioned first piezoelectric substrate and the aforementioned second piezoelectric substrate, the aforementioned piezoelectric substrate between the electrodes is polarized parallel to the aforementioned longitudinal direction, and polarization directions of the aforementioned regions adjacent to each other are mutually opposite in parallel.

Still furthermore, it is preferable that
each of the aforementioned regions of the aforementioned first piezoelectric substrate or the aforementioned second piezoelectric substrate have a structure in which a plurality of electrode layers and a plurality of piezoelectric material layers formed of a piezoelectric material are alternately laminated in a thickness direction of the aforementioned first piezoelectric substrate or the aforementioned second piezoelectric substrate,
the aforementioned piezoelectric material layer between the aforementioned electrodes in each of the regions is polarized parallel to the aforementioned thickness direction,
polarization directions of the aforementioned piezoelectric material layers adjacent to each other in the aforementioned thickness direction are mutually opposite in parallel,
the aforementioned plurality of electrode layers in the aforementioned each region are grouped into two electrode groups, and the electrode layers within the same electrode group are electrically connected to each other.

Still furthermore, it is preferable that
each of the aforementioned regions of the aforementioned first piezoelectric substrate or the aforementioned second piezoelectric substrate has a structure in which a plurality of electrode layers and a plurality of piezoelectric material layers formed of a piezoelectric material are alternately laminated in the aforementioned longitudinal direction,
the aforementioned piezoelectric layer between the aforementioned electrodes in each of the regions is polarized parallel to the aforementioned longitudinal direction,
the aforementioned plurality of electrode layers in the aforementioned each region are grouped into two electrode groups, and the electrode layers within the same electrode group are electrically connected to each other.

Still furthermore, it is preferable that
an electrical connection portion, which is to be connected to the external circuit, of the aforementioned input section is formed on a side face along the longitudinal direction and at a vibrational node portion in the aforementioned longitudinal direction of the aforementioned one of the piezoelectric substrates;
an electrical connection portion, which is to be connected to the external circuit of the aforementioned output section, is formed on a side face along the longitudinal direction and at a vibrational node portion in the aforementioned longitudinal direction of the aforementioned other of the piezoelectric substrates; and
an electrical connection between the aforementioned electrically connection portion, which is to be connected to the outside, of the aforementioned input section and the external circuit and an electrical connection between the aforementioned electrical connection portion, which is to be connected to the outside, of the aforementioned output section and the external circuit, and mechanical connections to support the piezoelectric transformer are performed via conductors.

Still furthermore, it is preferable that a belt-like electrode extending in a width direction, which is perpendicular to the aforementioned longitudinal direction, is provided at a central portion in the aforementioned longitudinal direction on at least one of the aforementioned first main face and the aforementioned second main face of the aforementioned second piezoelectric substrate, and polarization directions in two regions divided by the aforementioned belt-like electrode in the aforementioned longitudinal direction are parallel in the aforementioned longitudinal direction and mutually opposite.

Still furthermore, it is preferable that on at least one of the aforementioned first main face and the aforementioned second main face of the aforementioned second piezoelectric substrate, at least two belt-like electrodes are provided that respectively extend perpendicular to the aforementioned longitudinal direction of the aforementioned piezoelectric substrate, and a polarization direction of a region sandwiched between the aforementioned two belt-like electrodes is parallel to the aforementioned longitudinal direction.

Still furthermore, in the aforementioned piezoelectric transformer, it is preferable that contacting faces of the connector and the piezoelectric substrate are positioned at vibrational loop portions; and the length of the contacting faces in the longitudinal direction of the piezoelectric substrate is 0.05 to 0.4 of the length of the piezoelectric substrate, more preferably, 0.1 to 0.3 thereof.

According to a second aspect of the present invention, there is provided a piezoelectric transformer, characterized by comprising:
at least two piezoelectric substrates respectively including two main faces opposite to each other, the at least two piezoelectric substrates including a first piezoelectric substrate and a second piezoelectric substrate, and
a connector either formed or disposed as a ring in which an air gap is provided, wherein
the aforementioned first piezoelectric substrate and the aforementioned second piezoelectric substrate are disposed such that the aforementioned main faces of the first and second piezoelectric substrates are opposed to each other, and the first and second piezoelectric substrates are connected together between the aforementioned main faces via the aforementioned connector; and
an input section is provided in the aforementioned first piezoelectric substrate, and an output section being provided in the aforementioned other of the piezoelectric substrates.

The aforementioned piezoelectric substrate is capable of operating according to radially-expanding vibrations. In this case, the aforementioned connector provided between the aforementioned first piezoelectric substrate and the aforementioned second piezoelectric substrate is positioned at a vibrational loop portion of a radially-expanding vibration of the aforementioned first piezoelectric substrate and the aforementioned second piezoelectric substrate.

In addition, it is preferable that an electrode is provided on each of the aforementioned two main faces of each of the aforementioned first piezoelectric substrate and the aforementioned second piezoelectric substrate, and the aforementioned first piezoelectric substrate and the aforementioned second piezoelectric substrate are respectively polarized in a direction perpendicular to the aforementioned main faces.

Furthermore, it is preferable that a circular electrode is provided at a central portion of at least one of the aforementioned main faces of at least one of the aforementioned first piezoelectric substrate and the aforementioned second piezoelectric substrate, a ring-like electrode is provided at an outer edge portion of the at least one of the main faces of the at least one of the first and second piezoelectric substrates, and the at least one of the aforementioned first piezoelectric substrate and the aforementioned second piezoelectric substrate between the aforementioned circular electrode and the aforementioned ring-like electrode is polarized in a radial direction.

Still furthermore, it is preferable that at least one of the aforementioned first piezoelectric substrate and the aforementioned second piezoelectric substrate has a structure in which a plurality of electrode layers and a plurality of piezoelectric material layers formed of a piezoelectric material are alternately laminated in a thickness direction, the aforementioned plurality of electrode layers are alternately electrically connected, and the electrode layers adjacent to each other are insulated in terms of direct current.

According to a third aspect of the present invention, there is provided a piezoelectric transformer, characterized in that
at least two piezoelectric substrates having a plane plate shape and made of a piezoelectric material are connected via at least one connector having a disk shape and made of an insulating material,
the aforementioned at least two piezoelectric substrates include a first piezoelectric substrate and a second piezoelectric substrate,
the aforementioned first piezoelectric substrate and the aforementioned second piezoelectric substrate are connected via the aforementioned connector of the at least one connector; and
an input section is provided in one of the aforementioned first piezoelectric substrate and the aforementioned second piezoelectric substrate, and an output section being provided in the other of the first and second piezoelectric substrates.

According to the third aspect of the present invention, the piezoelectric transformer can be obtained in which a high power can be input, and input-output insulation can be implemented.

In the piezoelectric transformer of the above-mentioned third aspect, it is preferable that the aforementioned first piezoelectric substrate and the aforementioned second piezoelectric substrate respectively include a first main face and a second main face,
an electrode layer is provided on each of the aforementioned first main face and the aforementioned second main face of each of the aforementioned first piezoelectric substrate and the aforementioned second piezoelectric substrate, and
the aforementioned first piezoelectric substrate and the aforementioned second piezoelectric substrate between the aforementioned electrode layers are respectively polarized in a direction perpendicular to the aforementioned first main faces.

In addition, it is preferable that at least one of the aforementioned first piezoelectric substrate and the aforementioned second piezoelectric substrate has a structure in which a plurality of electrode layers and a plurality of piezoelectric layers formed of a piezoelectric material are alternately laminated in a thickness direction, and the aforementioned plurality of electrode layers are grouped into two electrode groups in which the electrode layers are alternately electrically connected.

In the above structure, since the impedance can be reduced, a high voltage step-up ratio or a large voltage step-down ratio can be obtained.

Furthermore, preferably, the aforementioned electrode layers provided on the aforementioned first piezoelectric substrate and the aforementioned second piezoelectric substrate have circular shapes. Since the electrode is circular, radially-expanding vibrations can be easily obtained.

Still furthermore, preferably, the aforementioned first main faces and the aforementioned second main faces of the aforementioned first piezoelectric substrate and the aforementioned second piezoelectric substrate have square shapes and a center of a circle drawn to be inscribed in the aforementioned square coincides with a center of the aforementioned connector provided between the aforementioned first piezoelectric substrate and the aforementioned second piezoelectric substrate.

Still furthermore, preferably, sizes of main faces of the aforementioned connector, which are opposed to the aforementioned main faces of the aforementioned first piezoelectric substrate and the aforementioned second piezoelectric substrate, are equal to or smaller than circles drawn to be inscribed in peripheries of the aforementioned main faces of the aforementioned first piezoelectric substrate and the aforementioned second piezoelectric substrate.

In the above structure, since a surface area for heat radiation is large, heat generation can be minimized. This enables high power to be generated.

Still furthermore, in the aforementioned piezoelectric transformer according to one of the above-described first to third aspects, it is preferable that
the aforementioned at least two piezoelectric substrates further include a third piezoelectric substrate,
the aforementioned third piezoelectric substrate is set to either the input section or the output section, and
the aforementioned first to third piezoelectric substrates are disposed so that the input section and the output section are disposed mirror symmetric.

In the above symmetric structure, spurious vibrations are not easily caused in the piezoelectric substrates, and vibrations can efficiently be transferred between the intermediate piezoelectric substrate and the piezoelectric substrates located at both sides thereof.

In this case, it is preferable that the aforementioned third piezoelectric substrate has the same structure as that one of the aforementioned first piezoelectric substrate and the aforementioned second piezoelectric substrate, the other one of the aforementioned first piezoelectric substrate and the aforementioned second piezoelectric substrate include a symmetry plane, and the aforementioned first piezoelectric substrate, the aforementioned second piezoelectric substrate, and the aforementioned third piezoelectric substrate are disposed mirror symmetric with respect to the aforementioned symmetry plane as the center.

In addition, in the piezoelectric transformer according to the second aspect, the piezoelectric substrates and the electrodes provided on the piezoelectric substrates may be shaped rotationally symmetric with respect to the same axis. Furthermore, the disposition may be made such that a center of the ring-like connector disposed in a concentric-circular state overlaps with the center of gravity of the plane plate of the aforementioned piezoelectric substrate. As a method for connecting the two piezoelectric substrates with the connector being provided therebetween, the piezoelectric substrates and the connector may be bonded with an adhesive, the connector and the piezoelectric substrates may be integrally formed, or the connector and the piezoelectric substrates may be fitted with each other.

Still furthermore, in the piezoelectric transformer according to one of the above-described first to third aspects , preferably, an adhesive is used to connect the aforementioned piezoelectric substrates and the aforementioned connector.

Still furthermore, in the piezoelectric transformer according to one of the above-described first to third aspects , it is preferable that the aforementioned piezoelectric substrates and the aforementioned connector are made of ceramic materials, and the connection of the aforementioned piezoelectric substrates and the aforementioned connector is formed through integral firing.

Still furthermore, in the piezoelectric transformer according to one of the above-described first to third aspects , preferably, the aforementioned connector is made of a piezoelectric ceramic material, and is polarized perpendicular to the aforementioned first main face of the aforementioned first piezoelectric substrate.

For the material of the aforementioned connector, a material of high in rigidity such as epoxy resin or polyimide resin may be used. The plural piezoelectric substrates to be used as described above are set on molds of an injection molding machine, and in that state, the resin is subjected to injection molding. Thereby, the components for the transformer can be easily manufactured. Furthermore, since the insulation material is used for the connector, the region between the input and the output can be insulated in terms of direct current.

### BRIEF DESCRIPTION OF THE DRAWINGS

Figs.1A to 1C are views for explaining a piezoelectric transformer according to a first embodiment of the present invention and for explaining an operation thereof, Fig.1A is a schematic perspective view, Fig.1B is a view showing stress distribution, and Fig.1C is a view showing amplitude distribution of displacement;
Fig.2 is a schematic perspective view for explaining a piezoelectric transformer according to a second embodiment of the present invention;
Figs.3A and 3B are a schematic perspective view and a schematic right side view, respectively, for explaining a piezoelectric transformer according to a third embodiment of the present invention;
Figs.4A and 4B are a schematic perspective view and a schematic right side view, respectively, for explaining a piezoelectric transformer according to a fourth embodiment of the present invention;
Fig.5 is a schematic perspective view for explaining a piezoelectric transformer according to a fifth embodiment of the present invention;
Fig.6 is a schematic perspective view for explaining a piezoelectric transformer according to a sixth embodiment of the present invention;
Fig.7 is a schematic perspective view for explaining a piezoelectric transformer according to a seventh embodiment of the present invention;
Fig.8 is an exploded schematic perspective view for explaining a piezoelectric transformer according to a seventh embodiment of the present invention;
Fig.9 is a schematic perspective view showing a state in which a piezoelectric transformer according to a first to seventh embodiments of the present invention is mounted to a printed wiring board;
Fig.10 is a schematic perspective view for explaining a piezoelectric transformer according to an eighth embodiment of the present invention;
Figs.11A and 11B are views showing a vibration state of a piezoelectric transformer according to an eighth embodiment of the present invention, Fig.11A is a view showing stress distribution, and Fig.11B is a view showing amplitude distribution of displacement;
Fig.12 is a schematic perspective view for explaining a piezoelectric transformer according to a ninth embodiment of the present invention;
Figs.13 to 16 are schematic perspective views showing piezoelectric substrates constituting piezoelectric transformers according to the eighth and ninth embodiments of the present invention;
Figs.17A and 17B are a schematic perspective view and an exploded schematic perspective view, respectively, for explaining a structure of a piezoelectric transformer according to a tenth embodiment of the present invention;
Figs.18A and 18B are views showing vibration states of the piezoelectric transformer shown in Figs.17A and 17B, and Figs.18C and 18D are views respectively showing displacement distribution and stress distribution of a basic radial vibration in a radially-expanding direction of the piezoelectric transformer shown in Figs.17A and 17B;
Fig.19 is an exploded schematic perspective view showing a piezoelectric transformer utilizing a third order mode of the tenth embodiment of the present invention;
Figs.20A and 20B are views showing vibration states of the piezoelectric transformer shown in Fig.19, and Figs.20C and 20D are views respectively showing displacement distribution and stress distribution of a radially-expanding vibration in a radially-expanding direction of the piezoelectric transformer shown in Fig.19;
Fig.21 is a schematic perspective view for explaining a piezoelectric transformer according to an eleventh embodiment of the present invention;
Figs.22A to 22D are schematic perspective views for explaining structures of connectors preferably used for the piezoelectric transformers according to the tenth and eleventh embodiments of the present invention;
Figs.23A to 23D, 24A, 24B, 25A, 25B, 26A and 26B are schematic perspective views for explaining structures of piezoelectric substrates preferably used for the piezoelectric transformers according to the tenth and eleventh embodiments of the present invention;
Fig.27 is a schematic perspective view for explaining a piezoelectric transformer according to a twelfth embodiment of the present invention;
Fig.28 is a schematic perspective view for explaining a piezoelectric transformer according to a thirteenth embodiment of the present invention; and
Figs.29A to 29C are views for explaining a conventional ROSEN type piezoelectric transformer and for explaining an operation thereof, Fig.29A is a schematic perspective view, Fig.29B is a view showing stress distribution, and Fig.29C is a view showing amplitude distribution of displacement.

### EMBODIMENTS

Next, embodiments according to the present invention will be explained with reference to drawings.

### (First to Seventh Embodiments)

### (First Embodiment)

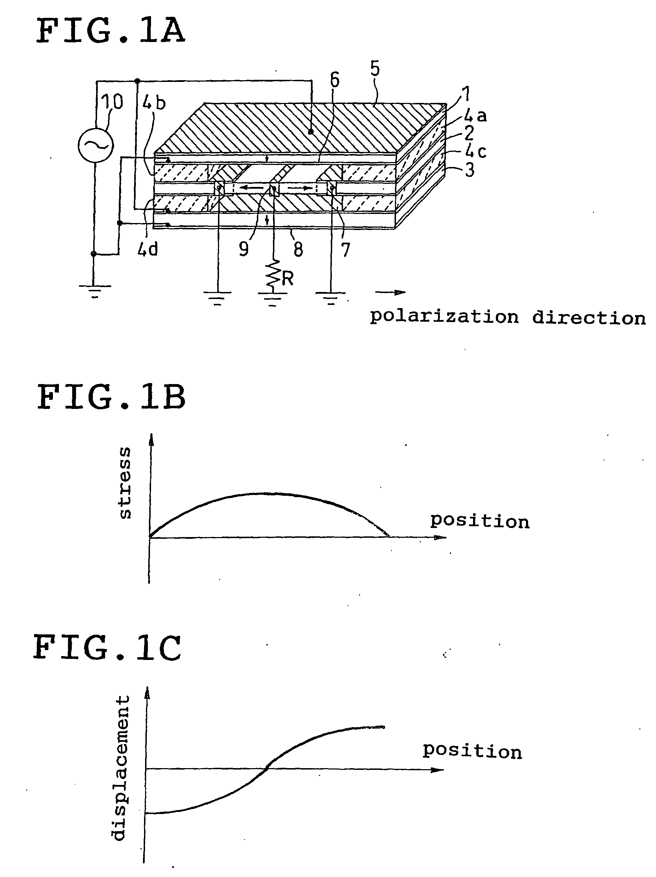

Figs.1A to 1C show a structure of a piezoelectric transformer of a first embodiment according to the present invention. The first embodiment is presented to describe a basic structure of piezoelectric transformers according to second to seventh embodiments that will be subsequently described.

Piezoelectric ceramic substrates (each of which will hereinbelow referred to as a piezoelectric substrate) 1, 2 and 3 each having a plane plate shape are laminated with connectors 4a, 4b, 4c, and 4d being sandwiched therebetween at longitudinal end portions thereof. Adhesive layers (not shown) are formed on mutually contacting faces of the three piezoelectric substrates and the connectors. Thus, the piezoelectric transformer are integrally structured. Air gaps are formed on opposing portions of the piezoelectric substrates opposing each other, where the connectors are not disposed. Mutually opposing electrodes 5 and 6 are formed on substantially entire portions of two main faces of the upper first piezoelectric substrate 1, which is one of the three piezoelectric substrates 1, 2, and 3. Similarly, electrodes 7 and 8 are formed on the lower third piezoelectric substrate 3. In addition, a strip-like electrode 9 extending perpendicular to the longitudinal direction is formed on a main face at a longitudinally central portion of the intermediate second piezoelectric substrate 2.

Hereinbelow, operational principles are described. First, a description will be made regarding a case where the first piezoelectric substrate 1 and the third piezoelectric substrate 3 are set to input section, and the second piezoelectric substrate 2 is set to an output section. An alternating current (AC) voltage waveform having a frequency having a longitudinal length of a halfwavelength is applied to the electrodes 5, 6, 7 and 8 provided on the piezoelectric substrates 1 and 3. The piezoelectric substrates 1 and 3 excite a standing wave having the halfwavelength of a mechanical vibration resulting from piezoelectric resonance with the node located at the longitudinal central portion. A stress distribution and a displacement amplitude distribution in the above case are shown in Figs.1B and 1C, respectively.

Then, mechanical vibration energy of the piezoelectric substrates 1 and 3 is propagated to the second piezoelectric substrate 2 provided on the substrates via the connectors 4a, 4b, 4c, and 4d. Thereby, longitudinal mechanical stretching vibrations are generated in a halfwavelength mode. The mechanical vibration energy is taken out as a high voltage current stepped up by the electrode 9 according to a piezoelectric longitudinal effect. The energy is then applied to a load R.

The voltage variation ratio is determined according to the ratio between input impedance and output impedance. Voltage step-down operation can therefore be performed through changing input and output electrical connections from each other.

The above-described piezoelectric transformer of the present invention enables the achievement of high outputs, high safety, low frequency operation, miniaturization, high voltage step-up ratios, high efficiency, and high vibrational stability. These are described hereinbelow in detail.

The first subject is to achieve high outputs. The high outputs can be achieved for the following reasons. Since the air gaps are provided, most of the portions of the piezoelectric substrates set to the input sections are separated from the piezoelectric substrate set to the output section. Thereby, on fixed faces of the input sections and the output section, thermal loss due to the difference in the material property values related to the mechanical vibration characteristics can be significantly reduced, and consequently, thermal generation can be reduced. In addition, because of the air gaps formed by the connectors provided between the input section and the output section, since the per unit volume heat radiation area is increased, cooling effects are increased. Thus, the piezoelectric transformer is advantageous to generate high outputs.

The second subject is to achieve high safety. With the connectors provided between the input sections and the output section, since the air gaps are formed therebetween, long creeping distances can be secured, and inter input output dielectric strength can be significantly improved. Thereby, inter input output dielectric characteristics can be prevented from breakdown.

The third subject is to achieve low-frequency operation. This can be achieved for the following reasons. Through the connection of the input sections and the output section via the connectors, the piezoelectric transformer vibrates in a state where the mass of the output section is added to vibrators forming the input sections. This causes reduction in the resonance frequency of the overall mechanical vibration system that includes the input sections and the output section. The piezoelectric transformer is thereby excited to resonantly vibrate at a frequency that is further lower than that in a case where only the input section is operated to vibrate. In specific, when the vibration mode and the device length, which is the longitudinal length, are fixed to be constant, the piezoelectric transformer can be operated at an even lower frequency.

The fourth subject is to achieve miniaturization. According to the above-described structure, when the device length is constant, the operation can be performed at an even lower frequency. For this reason, when the operation frequency is constant, the device length can be made even shorter. Thus, the piezoelectric transformer is structured advantageously for miniaturization.

The fifth requirement is to achieve high voltage step-up ratios. As shown in Fig.1A, in the input sections, the electrodes are provided on the two main faces, and the strip-like electrode extending in the width direction is provided in the longitudinally central portion of the output section. In this structure, the input impedance can be made lower than the output impedance. In addition, by using a piezoelectric substrate having a reduced thickness, the output impedance can be increased. Consequently, design is can be made easily for the voltage step-up ratio that is determined according to the square root of the ratio between the input and output impedances.

The sixth subject is to achieve high efficiency. Since the piezoelectric transformer is structured as shown in Fig.1A, either in the input sections and the output section, electrode external connection portions can be provided at vibrational node portion. In this case, interference is less in piezoelectric vibration, thereby allowing high efficiency to be expected.

The seventh subject is to achieve high vibrational stability. Since the input electrode is disposed on the entirety of the main face of the plane-plate-like board, vibrations in one wavelength mode do not easily occur. This enables even more stable halfwavelength resonant vibrations to be generated.

### (Second Embodiment)

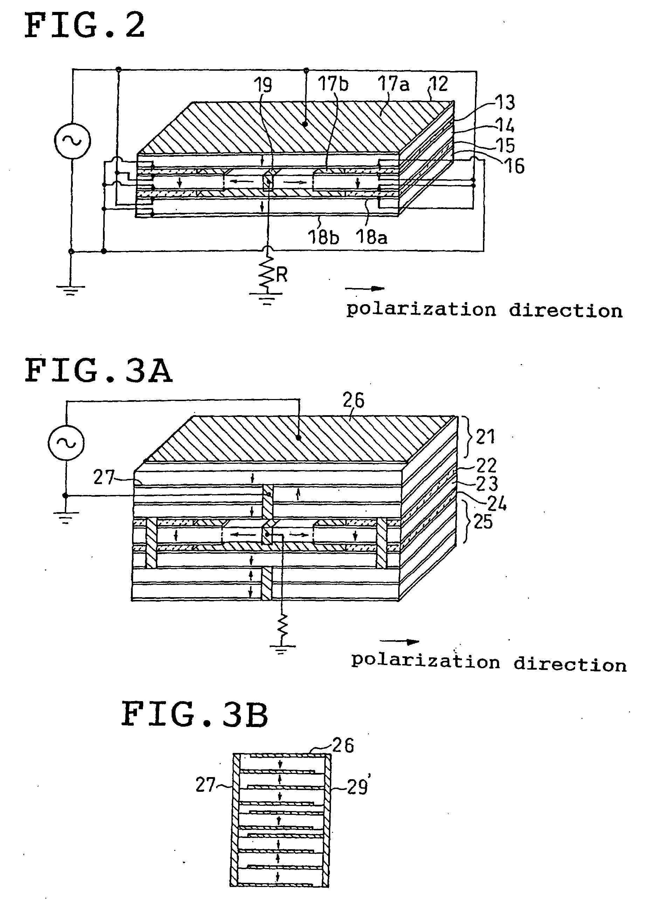

Fig.2 is a perspective view of a piezoelectric transformer according to a second embodiment. The piezoelectric transformer uses ceramic piezoelectric substrates obtained by sintering an ordinary PZT material, which is an ordinary piezoelectric transformer material. A first piezoelectric substrate 12 and a third piezoelectric substrate 16 having input sections are connected to a second piezoelectric substrate 14 having an output section. The substrates are connected via connectors 13 and 15 that are formed of a PZT ceramic and are provided in longitudinal end portions. In this case, contacting faces of the respective piezoelectric substrates and the connectors are bonded together by using a thermosetting epoxy adhesive. Thus, the piezoelectric transformer is integrally structured. Air gaps are formed in portions where the connectors are not disposed. The piezoelectric transformer has a size of 30 mm × 5 mm × 5 mm. On two main faces of the first piezoelectric substrate 12 forming the input section, an electrode 17a and an electrode 17b are formed to oppose each other. Similarly, on the third piezoelectric substrate 16 forming the input section, an electrode 18a and an electrode 18b are formed to oppose each other. In addition, a strip-like electrode 19 extending perpendicular to the longitudinal direction is formed on main faces in a longitudinally central portion of the intermediate second piezoelectric substrate forming the output section 14.

The respective electrodes were formed such that Pd-Ag conductive paste is used, and electrode patterns were formed thereon according to a screen printing method. Polarization processing was performed in oil, and thereafter, aging was performed. In this way, the piezoelectric substrates were produced.

Each of the upper and lower first and third piezoelectric substrates 12 and 16 is polarized in the thickness direction, and the intermediate second piezoelectric substrate 14 forming the output section is polarized in the longitudinal direction. However, the intermediate piezoelectric substrate 14 was formed to have two regions in the longitudinal direction at the border of the longitudinally central portion. The two regions were polarized in mutually opposing parallel directions. The length of the longitudinal polarization region of the intermediate piezoelectric substrate 14 was determined according to conditions for impedance matching with a load R.

Regions other than the longitudinal polarization region of the intermediate second piezoelectric substrate 14 are preferably polarized in the thickness direction of the piezoelectric substrate 14. In this case, when wiring is performed as shown in Fig.2, each of the areas polarized to the thickness direction can be operated as a part of the input section. Also, the connectors 13 and 15 are preferably polarized parallel to the thickness direction of the respective piezoelectric substrate.

### (Third Embodiment)

Figs.3A and 3B illustrate a piezoelectric transformer according to a third embodiment. Fig. 3A is a perspective view of the piezoelectric transformer, and Fig.3B is a right side view thereof. As shown in Fig.3A, the piezoelectric transformer is formed to include a second piezoelectric substrate 23 formed by sintering a PZT piezoelectric ceramic into a monolithic plate, a first piezoelectric substrate 21 and a third piezoelectric substrate 25 that are respectively formed to have a multilayer structure in which PZT piezoelectric ceramic layers and electrodes are alternately disposed in the thickness direction. The aforementioned substrates are bonded together using a thermosetting epoxy adhesive together via connectors 22 and 24 respectively formed of a PZT ceramic. Thus, the piezoelectric transformer is integrally structured. The direction along which the piezoelectric substrates are connected and laminated is the same as the overlay direction of the first piezoelectric substrate 21. Except for the piezoelectric multilayer structure used for the first piezoelectric substrate 21, the structure of the piezoelectric transformer of the present embodiment is similar to that of the second embodiment. In the present embodiment, the first and third piezoelectric substrates 21 and 25 are respectively set to input sections, and a longitudinally central portion of the second piezoelectric substrate 23 is set to an output section.

In the first and third piezoelectric substrates 21 and 25, an alternating current is input between an electrode group 26 and another electrode group 27 opposing thereto. As shown in Fig.3B, the electrode group 26 is formed such that inner electrodes formed between piezoelectric layers in the lamination direction are alternately electrically connected through a side face electrode 29'. Each of the piezoelectric multilayer substrates is polarized in the thickness direction, and an each pair of the piezoelectric layers adjacent to each other in the lamination direction are polarized in mutually opposing parallel directions. In the multilayer structure thus fabricated, high voltage step-up ratios can be obtained.

### (Fourth Embodiment)

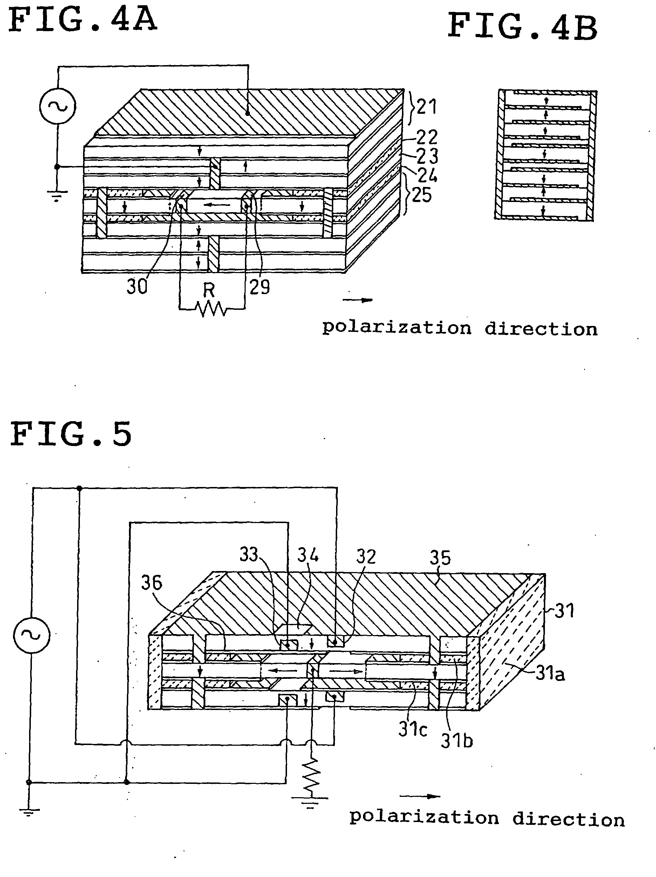

Figs.4A and 4B illustrate a piezoelectric transformer according to a fourth embodiment. Except for the polarization structure of the second piezoelectric substrate 23 having the output section, the piezoelectric transformer of the present embodiment is the same as that of the third embodiment. In the present embodiment, the second piezoelectric substrate 23 is formed such that an electrode 29 and an electrode 30 are respectively formed on its opposing main faces at two portions in the longitudinal direction, and the polarization is set in the longitudinal direction in a piezoelectric substrate that connects the electrodes 29 and 30. The positions where the electrodes 29 and 30 are formed are determined according to conditions for impedance matching with the load. The electrodes 29 and 30 may respectively be provided to be connected to the two main faces and longitudinal side faces of the piezoelectric substrate.

By providing an electric pattern of the output side, inter input output electric insulation can be established, and the piezoelectric transformer has a strong structure against noise, such as power noise.

### (Fifth Embodiment)

Fig.5 shows a piezoelectric transformer of a fifth embodiment. The present embodiment is different from the piezoelectric transformer of the second embodiment in the shapes of the connectors and the position where the electrode is connected outside from the piezoelectric transformer. Other portions are similar to those described in the second embodiment.

In the present embodiment, a connector 31 is formed to include a portion 31a, which is connected to longitudinal end portions of respective piezoelectric substrates, and projecting portions 31b and 31c respectively sandwiched between two piezoelectric substrates. The projecting portions 31b and 31c are not only sandwiched between the respective piezoelectric substrates, but are also shaped to cover longitudinal end faces of the respective piezoelectric substrates. Thereby, since vibrations of the input side piezoelectric substrates can be efficiently transferred to the output side, the power conversion ratio can be increased.

The position where the electrode is connected to the outside from the piezoelectric transformer is provided on longitudinal side faces and at a longitudinally central portion of the respective piezoelectric substrate. For example, the structure is fabricated such that an electrode terminal 32 of the upper piezoelectric substrate is connected to an electrode 35 on the upper main face, an electrode terminal 33 is connected to an electrode 36 on the lower main face, and an input voltage or an output voltage is applied between the electrode terminals 32 and 33. In this structure (lower electrodes are not shown), short circuiting can be prevented through cutouts 34 each provided near a terminal of opposing electrodes on the upper and lower main faces.

### (Sixth Embodiment)

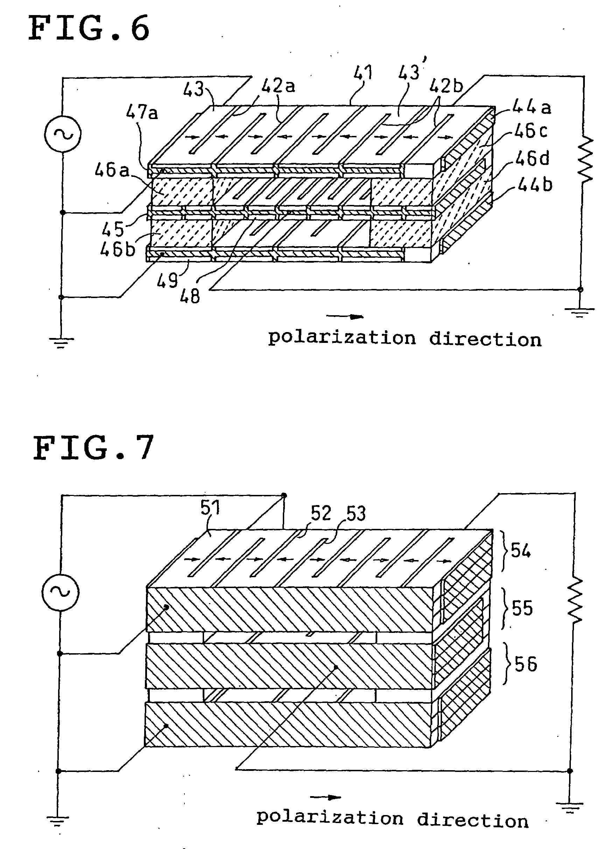

Fig.6 shows a piezoelectric transformer of a sixth embodiment. The piezoelectric transformer is formed to include a piezoelectric layer 43 made of a PZT piezoelectric ceramic sheet, a first piezoelectric substrate 43' on which inner electrodes 42a and 42b are alternately disposed in the longitudinal direction, a second piezoelectric substrate 48 similar to the first piezoelectric substrate 43', and a third piezoelectric substrate 49. These substrates are connected together via connectors 46a, 46b, 46c, and 46d each formed of a PZT ceramic by using a thermosetting epoxy adhesive. Thus, the piezoelectric transformer is integrally structured. The electrode forming method and the polarization method are similar to those employed in the second embodiment. In each of the first, second, and third piezoelectric substrates 43', 48, and 49, the piezoelectric layer is polarized in the longitudinal direction, and the piezoelectric layers adjacent to each other in the longitudinal direction are polarized to mutually opposite in the parallel direction.

An alternating current is input between an electrode group 47a and another electrode group. The electrode group 47a is formed such that inner electrodes 42a formed between the piezoelectric layers in the lamination direction are alternately electrically connected through a side face electrode. The aforementioned other electrode group includes the electrodes 42b in an interior portion opposing the electrode group 47a. Also the third piezoelectric substrate similarly operates as an input section. The electrode groups include electrodes 44a and 44b provided on their longitudinal end faces.

According to the structure in which the first and third piezoelectric substrate 43' and 49 are laminated in the longitudinal direction, piezoelectric longitudinal resonance having a large electromechanical coupling coefficient can be used. Thereby, electric energy can be converted to mechanical vibration energy at an even higher energy conversion efficiency to cause vibrations. Similarly, in the structure in which the second piezoelectric substrate 48 set to the output section is structured through lamination in the longitudinal direction, piezoelectric longitudinal resonance having a large electromechanical coupling coefficient can be used. Thereby, mechanical energy can be converted to electrical vibration energy at a high energy conversion efficiency to transfer the energy to an electric load. Since the energy conversion efficiency is high either in the input sections and the output section, the above-described structure is advantageous to improve the output level.

### (Seventh Embodiment)

Fig.7 shows a piezoelectric transformer of a seventh embodiment. The piezoelectric transformer is formed to include a first piezoelectric layer 54 having a multilayer structure, a second piezoelectric substrate 55 having a multilayer structure similar thereto, and a third piezoelectric substrate 56 having a multilayer structure similar thereto. The first piezoelectric layer 54 is formed such that electrodes are disposed on upper and lower main faces of a plurality of PZT piezoelectric ceramic sheet alternately in the longitudinal direction and linearly in the width direction, and the sheets are sintered to form an integrally unit. These substrates are bonded together via connectors each formed of a PZT ceramic by using a thermosetting epoxy adhesive. Thus, the piezoelectric transformer is integrally structured.

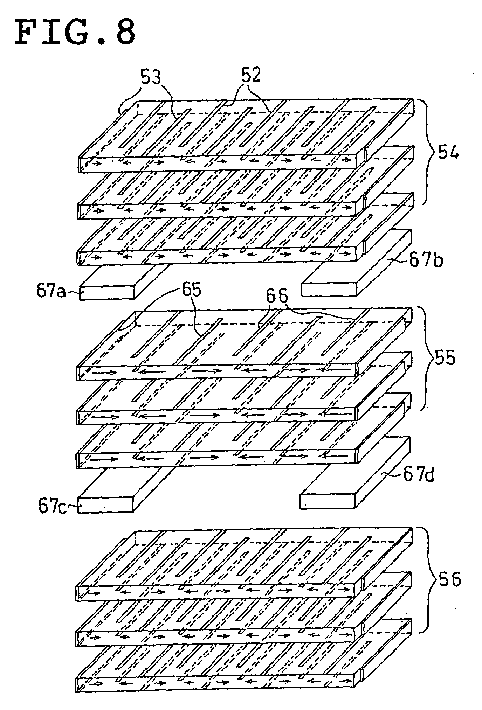

The above-described structure will be described in detail with reference to Fig.8. Fig.8 is an exploded view of the structure wherein the first piezoelectric layer 54 and the third piezoelectric substrate 56, which are respectively set to input sections, and the second piezoelectric substrate 55, which is set to an output section, are each formed of a piezoelectric sheet formed of three layers. On each of the piezoelectric sheets, electrode groups 53, 52, 65, 66, and the like are alternately provided linearly in the width direction. The respective electrode groups are coated thereon according to a screen printing method. The respective piezoelectric sheets are produced through integral sintering. The piezoelectric substrates for the input sections are bonded via connectors 67a, 67b, 67c, and 67d by using an epoxy adhesive. After the piezoelectric substrates are bonded, voltage is applied to inner electrodes, and interelectrode regions are polarized. The piezoelectric substrates for the input sections and the output section are respectively polarized in the longitudinal direction, and the adjacent regions on the piezoelectric sheets are polarized in mutually opposing parallel directions. An alternating voltage is applied between an electrode group and another electrode group opposing thereto. The electrode group is formed such that inner electrodes formed between the respective piezoelectric layers in the lamination direction are alternately electrically connected through a side face electrode.

In the structure in which the input section sheets are laminated in the thickness direction, the polarization directions of the interelectrode regions can be set substantially in parallel to the longitudinal direction. Thereby, piezoelectric longitudinal resonance having a high electromechanical coupling coefficient can be caused. In addition, electric energy can be converted to mechanical vibration energy at an even higher energy conversion efficiency to cause vibrations. Similarly, in the structure in which the output section is laminated in the longitudinal direction, piezoelectric longitudinal resonance having a high electromechanical coupling coefficient can be used. Thereby, mechanical energy can be converted to electrical vibration energy at a high energy conversion efficiency to transfer the energy to an electric load. Since the energy conversion efficiency is high either in the input sections and the output section, the above-described structure is advantageous to improve the output level. In addition, the structure in which the integral sheets are laminated in the longitudinal direction is advantageous in that the strength can be increased to resist breakdown due to tensile stress caused perpendicular to the longitudinal direction when the structure expands and contracts.

The above-described first to seventh embodiments are characterized as follows. As shown in Figs.1B and 1C, any one of the piezoelectric transformers can be operated to vibrate in the halfwavelength mode. In this case, since the connectors are provided in the longitudinal end portions, which are vibrational loop portions, vibrations of the input side substrates can be efficiently transferred to the output side substrate. Depending on the vibration mode, a connector can be provided in a longitudinally central portion of the substrate.

Furthermore, in each of the embodiments, description has been made with reference to the case where the three piezoelectric substrates are used. However, the third piezoelectric substrate may be eliminated, and the configuration may be made with only the first piezoelectric substrate and the second piezoelectric substrate. Still furthermore, In addition, four or more piezoelectric substrates may be laminated via connectors.

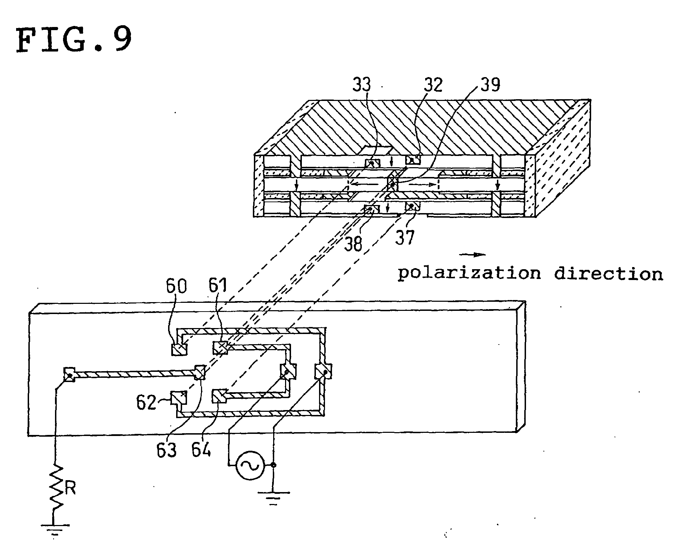

Hereinbelow, a description will be made regarding a method for mounting the piezoelectric transformer according to one of the above-described first to seventh embodiments on a printed substrate. Fig.9 illustrates the state of mounting of a piezoelectric transformer to a printed wiring board. Similarly to the fifth embodiment, the piezoelectric substrate has electrode external connection portions at widthwise end faces of respective piezoelectric substrates in longitudinally central portions. The external connection positions correspond to the vibrational nodes of the piezoelectric substrates. Portions in these positions can be used for electrical connection as well as for mechanical connection, that is, for fixing the piezoelectric transformer. The two connections can concurrently be implemented by applying solder between each of the piezoelectric transformer electrodes and the printed substrate. In the structure shown in Fig.9, electrode terminals 32, 33, 37, 38, and 39 provided on the piezoelectric transformer are soldered to electrode terminals 60 to 64. In specific, soldering is performed for the respective combinations of 32 and 61, 33 and 60, 37 and 64, 38 and 62, and 39 and 63. In this way, in the structure in which the piezoelectric transformer is electrically and mechanically connected to the printed substrate, it can be directly mounted in a reflow furnace to the printed substrate. Thereby, the manufacturing cost can be significantly reduced.

As described above, according to the first to seventh embodiments, high outputs, high safety, low frequency operation, miniaturization, high voltage step-up ratio, high efficiency, and high vibrational stability can be achieved.

### (Eighth and Ninth Embodiments)

Hereinbelow, eighth and ninth embodiments will be described. In the eighth embodiment, a basic structure and operational principles will be described. In the ninth embodiment, a more practical embodiment will be described.

### (Eighth Embodiment)

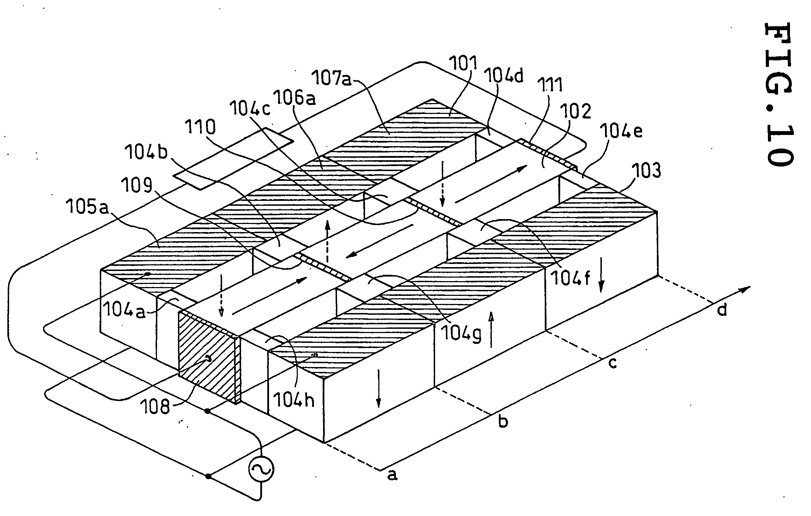

Fig.10 shows a piezoelectric transformer according to the eighth embodiment. Rectangular parallelepiped piezoelectric substrates 101, 102, and 103 formed of a piezoelectric material are laminated via connectors 104a, 104b, 104c, 104d, 104e, 104f, 104g, and 104h sandwiched therebetween. The three piezoelectric substrates and the connectors are integrally bonded through adhesive layers (not shown) applied on their mutual contacting faces. Air gaps are formed in portions where the piezoelectric substrates mutually oppose, and connectors are not disposed.

The three piezoelectric substrates in the longitudinal direction are equally divided into three regions, and the connectors are provided on the borders of the regions, and end portions of the piezoelectric substrates.

A piezoelectric substrate 101 has three divisional regions in the longitudinal direction. On first faces of the respective regions, an electrode 105a, an electrode 106a, and an electrode 107a are formed. On second faces on the reverse sides of the first faces, electrodes respectively opposing the electrodes on the first face are formed. The respective interelectrode regions are polarized perpendicular to the faces of the electrodes, and the polarization directions in the adjacent regions oppose in parallel to each other. The electrodes 105a, 106a, and 107a are electrically connected from one another, and the opposing electrodes are electrically connected from one another, respectively configuring electrode groups. The piezoelectric substrate 103 is structured in the same manner as that for the piezoelectric substrate 101.

The piezoelectric substrate 102 can be divided into three longitudinal regions. An electrode 108 and an electrode 111 are respectively formed on longitudinal end faces of the piezoelectric substrate. Electrodes 109 and 110 are respectively formed on border faces perpendicular to the longitudinal direction of the regions. The respective interelectrode regions are polarized perpendicular to the faces of the electrodes, and the polarization directions in the adjacent regions are longitudinally perpendicular and mutually opposite.

Hereinbelow, operational principles will be described.

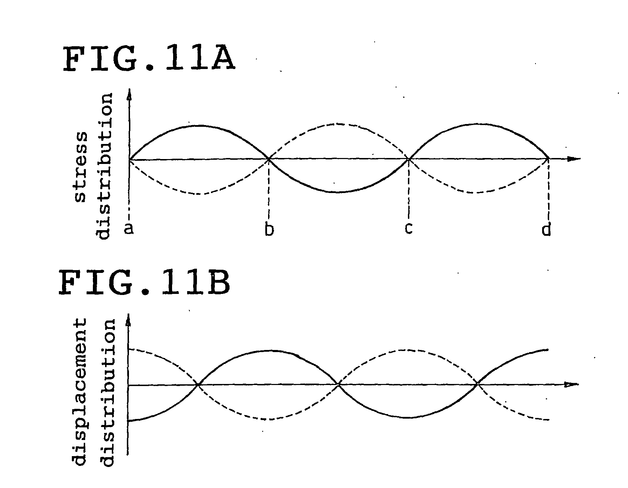

Description will be made referring to a case where the piezoelectric substrates 101 and 103 are respectively set to input sections, and the piezoelectric substrate 102 is set to an output section. An electrically connected group of the electrodes 105a, 106a, and 107a provided on the piezoelectric substrate 101 and three electrodes provided on the corresponding faces of the piezoelectric substrate 103 is used as an electrode group A. An electrically connected group of the electrodes provided in the reverse faces of the piezoelectric substrates 101 and 103 is used as an electrode group B. An AC voltage at the frequency having the longitudinal length of a 1.5 wavelength are applied between the electrode group A and the electrode group B. As a result, since the respective polarization directions in the three divisional regions of the piezoelectric substrates 101 and 103 are mutually opposite, according to a piezoelectric transverse effect, the adjacent regions perform stretching vibrations in the longitudinal direction in mutually opposite phases, and a standing wave having a 1.5 wavelength is excited in the longitudinal direction. A stress distribution and an amplitude distribution in the above case are shown in Figs.11A and 11B, respectively.

Mechanical vibration energy of the piezoelectric substrate 101 and 103 is propagated to the intermediate piezoelectric substrate 102 via the connectors 104a, 104b, 104c, 104d, 104e, 104f, 104g, and 104h provided in vibrational loop portions. Thereby, the piezoelectric substrate 102 performs stretching vibrations with a standing wave having a 1.5 wavelength in the longitudinal direction. In this case, in the three longitudinally divided regions, the adjacent regions expand and contract in mutually opposing phases; and since the polarization directions in the adjacent regions are longitudinally parallel and mutually opposite, phases of the voltage generated according to the piezoelectric longitudinal effect become the same, and stepped-up high voltage alternating currents can be obtained from the electrode 111 and the electrode 108.

The transformation ratio is proportional to the square root of the ratio between input impedance and output impedance. Therefore, voltage step-down operation can be performed by changing the input and output electrical connections from each other.

In the piezoelectric transformer of the present embodiment, a larger number of piezoelectric substrates may be connected via connectors, thereby allowing them to be extended as necessary.

In addition, a number N of longitudinal divisional regions of the respective piezoelectric substrates is at least two, and the upper limit is not specifically restricted. In practice, however, the upper limit is preferably set to 100.

The above-described piezoelectric transformer of the present invention enables the achievement of high outputs, high safety, low frequency operation, miniaturization, and high voltage step-up ratios. Hereinbelow, these are described in detail.

The first subject is to achieve high outputs. Increasing the volume is effective to achieve high outputs. According to the present structure, the volume can easily be increased in the longitudinal direction in units of a 1/2 wavelength without changing the frequency. Furthermore, because of the air gaps formed by the connectors in the input sections and the output section, since the per unit volume heat radiation area is increased, cooling effects are increased. Consequently, the piezoelectric transformer is advantageous to generate high outputs.

The second subject is to achieve high safety. With the connectors provided between the input sections and the output section, since the air gaps are formed therebetween, long creeping distances can be secured, and the inter input output dielectric strength can be significantly improved. Thereby, inter input output insulation can be prevented from breakage.

The third subject is to achieve low frequency operation. This can be achieved for the following reasons. According to the connection of the input sections and the output section via the connectors, the piezoelectric transformer vibrates in a state where the mass of the output section is added to vibrators forming the input sections. This works to reduce resonance frequency of the overall mechanical vibration system including the input sections and the output section. Thereby, the piezoelectric transformer resonantly vibrates at a frequency that is further lower than that in a case where only the input section is operated to vibrate. In specific, when the vibration mode and the device length, which is the longitudinal length, are constant, the piezoelectric transformer can be operated at an even lower frequency.

The fourth subject is to achieve miniaturization. According to the above-described structure, when the device length is constant, the operation can be performed at an even lower frequency. Conversely, when the operation frequency is constant, the device length can be made even shorter. Thus, the piezoelectric transformer is structured advantageously for miniaturization.

The fifth requirement is to achieve high voltage step-up ratios. As shown in Fig.10, in the input sections, the electrodes are provided on the two main faces, and the strip like electrode extending in the width direction is provided in the longitudinally central portion of the output section. In this structure, the input impedance can be made lower than the output impedance. In addition, using the piezoelectric substrate having a reduced thickness enables the output impedance to be increased. Consequently, design is can be made easily for voltage step-up ratios that are determined according to the square root of the ratio between the input output impedances.

In addition to the structure shown in Fig.10, a number of structures of the piezoelectric substrates exemplifying the present invention can be considered. Examples conceivable structures are described hereinbelow.

### (Ninth Embodiment)

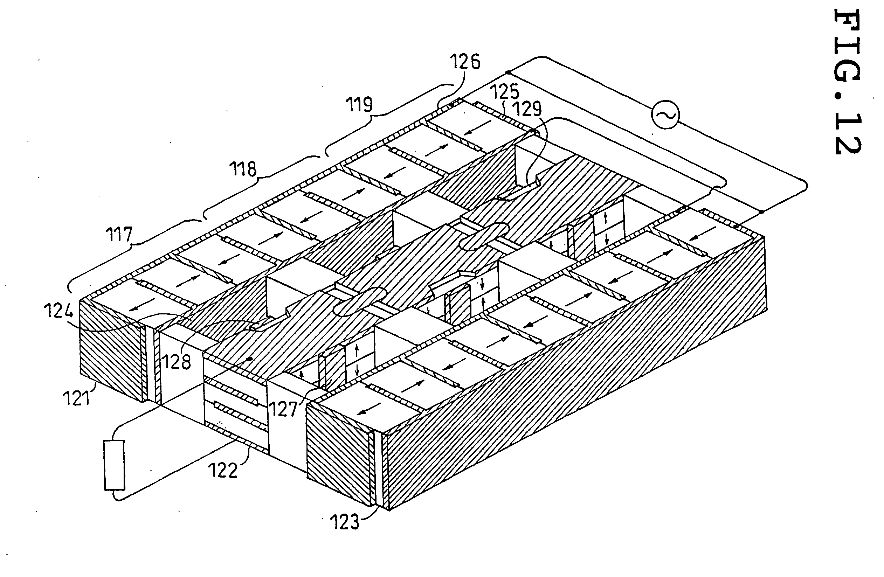

Fig.12 is a perspective view of a piezoelectric transformer according to a ninth embodiment.

The piezoelectric transformer uses ceramic piezoelectric substrates obtained by sintering an ordinary PZT material, which is an ordinary piezoelectric transformer material. The present embodiment will be described regarding a case where piezoelectric substrates 121 and 123 are respectively set to input sections, and a piezoelectric substrate 122 is set to an output section. To excite a standing wave having a 1.5 wavelength in the longitudinal direction for operation, the structure of the present embodiment is formed such that connectors are inserted in border portions in three longitudinally divided regions, which corresponds to vibrational loop portions, and contacting faces of the respective piezoelectric substrates and the connectors are bonded together by using a thermosetting epoxy adhesive. Air gaps are formed in portions where the connectors are not disposed. The piezoelectric transformer has a size of 30 mm × 10 mm × 5 mm.

The first piezoelectric substrate 121 forming the input section is formed of a piezoelectric multilayer substrate in which PZT piezoelectric ceramic sheets and electrode layers are alternately disposed in the longitudinal direction. A group in which inner electrodes formed between the piezoelectric sheets are alternately electrically connected through a side face electrode 124 is used as an electrode group 125, and another electrode group 126 opposing thereto is electrically connected through another side face electrode.

The polarization directions are longitudinally parallel and mutually opposite. However, in three longitudinally divided regions 117, 118, and 119, the two regions 117 and 119 at the two end portions and the intermediate region 118 are set to the polarization directions such that polarities in the polarization directions for connecting to the electrodes of the electrode group 125 or 126 oppose each other.

According to the above arrangement, when an AC voltage is applied from an external source, in the three longitudinally divided regions 117, 118, and 119, the two regions 117 and 119 at the two end portions and the intermediate region 118 vibrate in mutually opposing phases, and vibrations in a 1.5-wavelength mode is enabled to easily occur. The third piezoelectric substrate 123 is structured in the same manner as the piezoelectric substrate 121.

The second piezoelectric substrate 122 forming the output section is formed of a piezoelectric multilayer substrate in which PZT piezoelectric ceramic sheets and electrode layers are alternately disposed in the thickness direction. Inner electrodes of the piezoelectric multilayer substrate are equally divided into three regions. In each of the regions, a group in which the inner electrodes formed between piezoelectric sheets are alternately electrically connected through a side face electrode 127 is used as an electrode group, and another electrode group opposing thereto is electrically connected through another side face electrode 128. A cutout 129 is provided near an electrode terminal opposing each of the side face electrodes, thereby enabling shortcircuiting with the opposing electrode group to be prevented. The polarization directions in adjacent layers are set to mutually oppose in parallel.

In addition, side face electrodes of the three regions are connected so that polarities in the polarization direction of the adjacent regions oppose each other. Thereby, when the piezoelectric substrate is excited at a 1.5 wavelength, since the two regions at the two end portions and the intermediate region vibrate in mutually opposing phases, in phase AC voltages can be output.

The electrodes are formed such that Pd-Ag conductive paste is used, and electrode patterns are formed thereon according to a screen printing method.

Polarization is performed in oil, and thereafter, aging is performed. In this way, the piezoelectric multilayer substrate is produced.

By reducing the thickness of the multilayer body of the output substrate, the output impedance can be reduced, and the value of a matched load can be reduced. Conversely, by increasing the thickness of the multilayer body, the output impedance can be increased, and the value of a matched load can be increased.

Similarly, by changing the thickness of the multilayer body of the input substrate, the input impedance can be set to arbitrary value.

In the above, description has been made referring to the case the piezoelectric substrates are excited at the 1.5 wavelength. However, by extending them in units of 1/2 wavelengths, the piezoelectric transformer can be driven in a 2-wavelength mode or a higher mode.

In addition, in the sate shown Fig.12, the substrates of the respective input section and output section may be connected to each other in a state where each of the substrates is 90° rotated with respect to a central axis in the longitudinal direction.

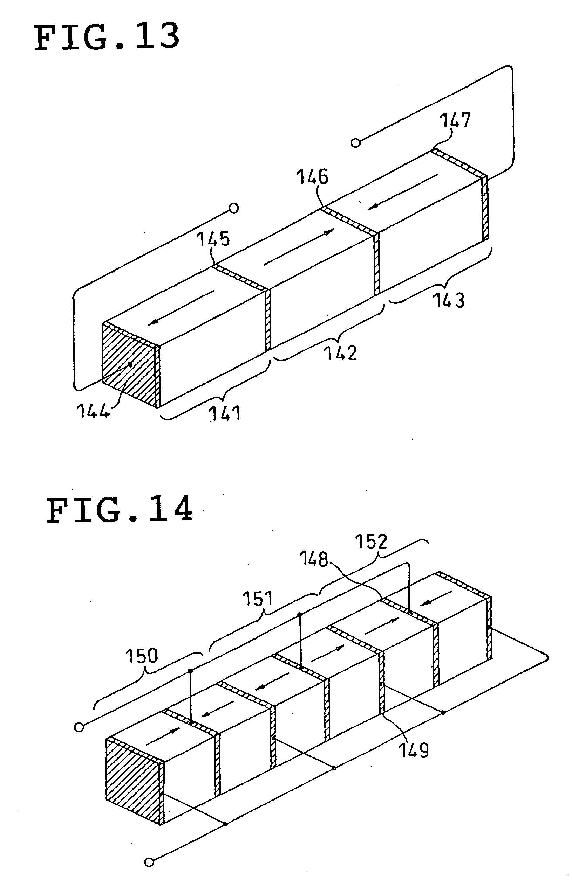

Furthermore, with respect to the configuration of the ninth embodiment, the piezoelectric substrates can be arranged in various other modes. Example modes will hereinbelow be described referring to Figs.13, 14, 15, and 16. The piezoelectric substrates are each capable of functioning either as an input section or as an output section. Thereby, depending on the combination of the piezoelectric substrates and the connection thereof, design is enabled for a piezoelectric transformer achieving desired input impedance and output impedance.

A piezoelectric substrate shown in Fig.13 is structured similar to the output section shown in Fig.10. That is, the substrate is formed of a multilayer body in which piezoelectric blocks are laminated with electrodes sandwiched between the blocks. Electrodes 144, 145, 146, and 147 are formed on end faces and border faces that are perpendicular to the longitudinal direction in three equally divided regions 141, 142, and 143. The respective interelectrode regions are polarized perpendicular to faces of the electrodes. The polarization directions in the regions adjacent to each other are longitudinally parallel and mutually opposite.

To control the piezoelectric substrate to function as an input section, AC voltages are applied to the electrodes 144 and 147. As a result, according to a piezoelectric longitudinal effect, the regions 141 and 143 vibrate in the same phase, and the region 142 vibrates in the opposite phase with respect to the regions 141 and 143, thereby allowing 1.5-wavelength vibrations to be caused.

In addition, to control the piezoelectric substrate to function as an output section, vibrations are generated with a 1.5 wavelength. Thereby, the regions 141 and 143 vibrate in the same phase, and the region 142 vibrates in the opposite phase with respect to the regions 141 and 143. In this case, the polarization directions in the regions 141 and 143 are identical, and the polarization direction in the region 142 is opposite to those of the regions 141 and 143. This enables voltages uniformed in phase to be series connected and to be taken out from the electrodes 144 and 147 located at the end portions.

The piezoelectric substrate is structured advantageously to achieve high input impedance when it is driven as an input section. Concurrently, the piezoelectric substrate is structured advantageously to achieve high output impedance when it is driven as an output section.

A piezoelectric substrate shown in Fig.14 is formed of piezoelectric multilayer substrates in which PZT piezoelectric ceramic sheets and electrode layers are alternately disposed in the longitudinal direction. A group in which inner electrodes formed between the piezoelectric sheets are alternately electrically connected is used as an electrode group 148, and another group corresponding thereto is used as an electrode group 149.

The polarization directions in the respective regions are longitudinally parallel and mutually opposite. However, in three longitudinally divided regions 150, 151, and 152, the two regions 150 and 152 located at the two end portions and the intermediate region 151 are set to the polarization directions such that polarities in the polarization directions for making connection to the electrodes of the electrode group 148 or 149 oppose each other.

To control the piezoelectric substrate to function as an input section, AC voltages are applied to the electrodes 148 and 149. As a result, according to a piezoelectric longitudinal effect, the regions 150 and 152 vibrate in the same phase, and the region 151 vibrates in the opposite phase with respect to the regions 150 and 152, thereby allowing 1.5-wavelength vibrations to be caused.

In addition, to control the piezoelectric substrate to function as an output section, it is excited with a 1.5 wavelength. Thereby, the regions 150 and 152 vibrate in the same phase, and the region 151 vibrates in the opposite phase with respect to the regions 150 and 152. In this case, the polarization directions of the regions 150 and 152 are identical, and the polarization direction of the region 151 is opposite to those of the regions 150 and 152. This allows voltages uniformed in phase to be series connected and to be taken out from the electrode 148 and 149 located at the end portions.

The structure of the piezoelectric substrate is advantageous to achieve low input impedance when it is driven as an input substrate in the manner of increasing the number of lamination layers and reducing the thickness of the multilayer body. Also, the structure is advantageous to achieve a low output impedance when it is driven as an output substrate in the same manner as mentioned above.

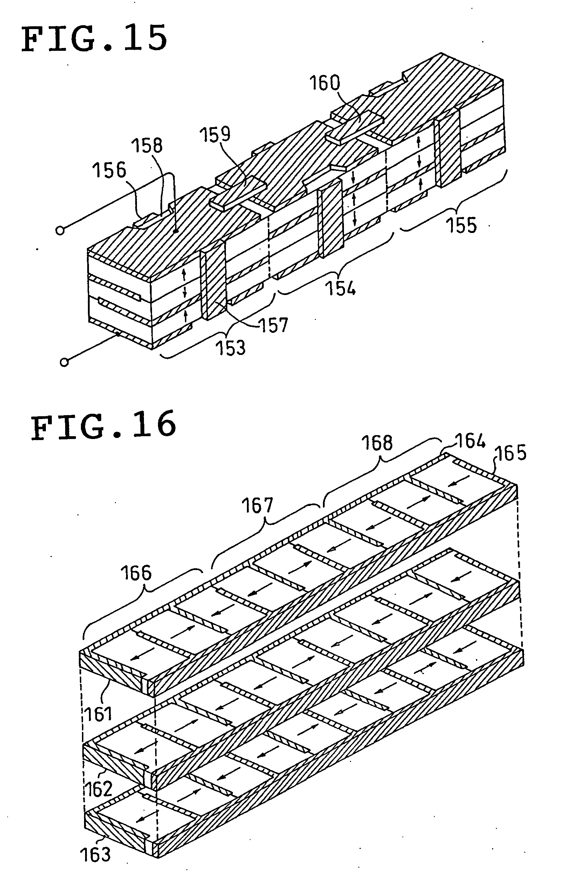

A piezoelectric substrate shown in Fig.15 is formed of piezoelectric multilayer substrates in which PZT piezoelectric ceramic sheets and electrode layers are alternately disposed in the thickness direction. Inner electrodes of the multilayer substrate are equally divided in the longitudinal direction into three regions 153, 154, and 155. In the region 153, a group in which the inner electrodes formed between piezoelectric sheets are alternately electrically connected through a side face electrode 156 is used as an electrode group, and another electrode group opposing thereto is electrically connected through another side face electrode 157. A cutout 158 is provided near an electrode terminal opposing the side face electrode, thereby enabling shortcircuiting with the opposing electrode group to be prevented.

The polarization directions in adjacent layers are set to mutually oppose in parallel.

In addition, side face electrodes of the three regions 153, 154, and 155 are connected so that polarities in the polarization direction of the regions 153, 154, and 155 oppose each other. Thereby, when the piezoelectric substrate is excited with a 1.5 wavelength, since the two regions located at the two end portions and the intermediate region vibrate in mutually opposing phases , in phase AC voltages can be output. In the example shown in Fig.15, connecting electrodes 159 and 160 are used to connect the region 153 and 155 and the region 154 so that polarities in the polarization directions oppose each other. When the connecting electrodes 159 and 160 are not provided, the respective regions are independently connected to loads. Thereby, a multioutput transformer can be obtained.

A piezoelectric substrate shown in Fig.16 has a thicknesswise multilayer structure to realize the performance equivalent to that of the input sections 121 and 123 of the piezoelectric transformer shown in Fig.12. A lamination method therefor may be such that piezoelectric substrates 161, 162, and 163 are laminated as a green sheet and are integrally sintered. Alternatively, the piezoelectric substrates 161, 162, and 163 may be respectively sintered and may be bonded together with an adhesive made of, for example, polyimide resin or epoxy resin. In addition, instead of inner electrodes, cross finger electrodes extending perpendicular to the longitudinal direction may be formed on the main faces of the piezoelectric substrates 161, 162, and 163. A group in which the inner electrodes or the cross finger electrodes are alternately electrically connected through a side face electrode 164 is used as an electrode group, and another electrode group is electrically connected to a side face electrode. In addition, the electrodes are equally in the longitudinal direction divided into three regions 166, 167, and 168.

The polarization directions in adjacent portions of the respective regions are longitudinally parallel and mutually opposite to each other. However, in three longitudinally divided regions 166, 167, and 168, the two regions 166 and 168 located at the two end portions and the intermediate region 167 are set to the polarization directions such that polarities in the polarization directions for connecting to the electrodes of the same electrode group 164 or 165 oppose each other. In this structure, when an AC voltage is applied from an external source, in the three longitudinally divided regions 166, 167, and 168, the two regions 166 and 168 located at the two end portions and the intermediate region 167 vibrate in mutually opposing phases, and vibrations in a 1.5-wavelength mode is enabled to easily occur.

Because of the lamination of the above-described piezoelectric substrates in the thickness direction, the number of lamination layers can be reduced, and the manufacturing costs can thereby be reduced. In addition, although breakdown stresses are generated during excitation, as shown in Fig.4, in the case where the electrodes are disposed on the faces that are perpendicular to the longitudinal direction, mechanical strengths of borders between the electrodes and the piezoelectric substrates are low. In this case, breakdown tends to develop from the border portions. However, when the electrodes are structured as shown in Fig.16, borders between the electrodes and the piezoelectric substrates, of which the mechanical strengths are low, can be made parallel to the longitudinal direction. This allows anti-breakdown strengths to be significantly increased. Thus, the structure is advantageous to achieve high outputs.

As described above, the eighth and ninth embodiments enable the achievement of high outputs, high safety, low frequency operation, miniaturization, and high voltage step-up ratios.

In each of the above-described piezoelectric transformers, the portions for electrically connecting to the outside are preferably positioned at the nodes of piezoelectric resonance of the piezoelectric transformer to prevent the mechanical vibrations from interference. An electrical connection is preferably made by providing, for example, a flexible substrate or an electrically conductive elastic material that uses solder, lead wire, and insulating material such as polyimide resin, and the like, between the electrodes positioned at a vibrational node and an external circuit.

The piezoelectric transformer is supported at node portions by using an elastic material such as a silicon adhesive. The piezoelectric transformer according to one of the first to seventh embodiments is supported at a central portion in the longitudinal direction by using an elastic material such as a silicon adhesive. Components can be reduced in number by using solders, which have been used for electrical connection, for mechanical connection. This eventually results in cost reductions. Furthermore, since the structure allows the electrical connection as well as mechanical connection to be made to the printed substrate, direct mounting can be performed on the printed substrate in a reflow furnace, thereby enabling manufacturing costs to be reduced.

Still furthermore, by changing the electrical connections, the described piezoelectric transformer can also be used either for stepping up the voltage or for stepping down the voltage. Figs.1A to 7, 10, and 12 each show the electrical connections for stepping up the voltage; however, the transformer can also be used for stepping down the voltage when the inputs and the outputs are reversed. The reversed connections of the inputs and the outputs would be able to be presented by reversing the relative descriptions in the respective embodiments.

In each of the first to ninth embodiments, the end portions in the longitudinal direction of the respective piezoelectric substrates and the border between the respective polarization regions correspond to the vibrational loop portions when the piezoelectric transformer is driven.

### (Tenth and Eleventh Embodiments)

Hereinbelow, tenth and eleventh embodiments will be described. In the embodiment, a basic structure and operational principles will be described; and in the eleventh embodiment, a more practical embodiment will be described.

### (Tenth Embodiment)

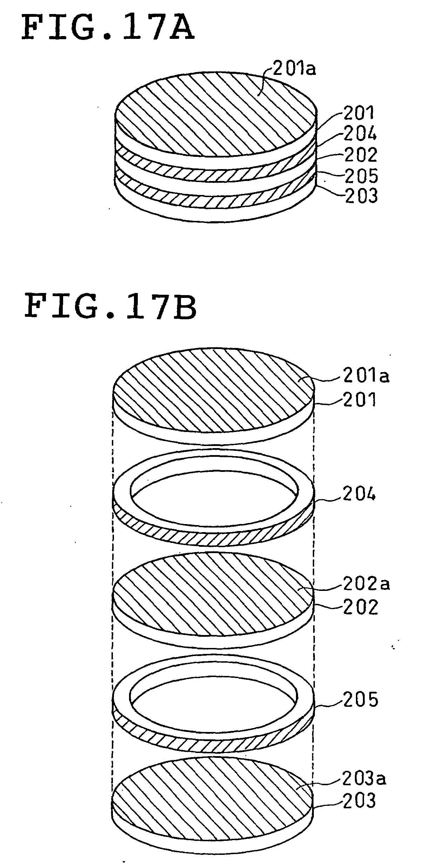

First, operational principles of the tenth and eleventh embodiments will be described with reference to Figs.17A and 17B. Fig.17A is a schematic perspective view for explaining a structure of a piezoelectric transformer according to the present embodiment. As shown in Fig.17B, the piezoelectric transformer is formed of a piezoelectric ceramic, and has a structure in which plane-plate-like piezoelectric substrates 201, 202, and 203 on which electrodes 201a, 202a, and 203a (only the electrodes on one face are shown) are formed, respectively are connected by a ring-like connector 204. Adhesive layers (not shown) are formed on mutually contacting faces, and the entirety is integrated.

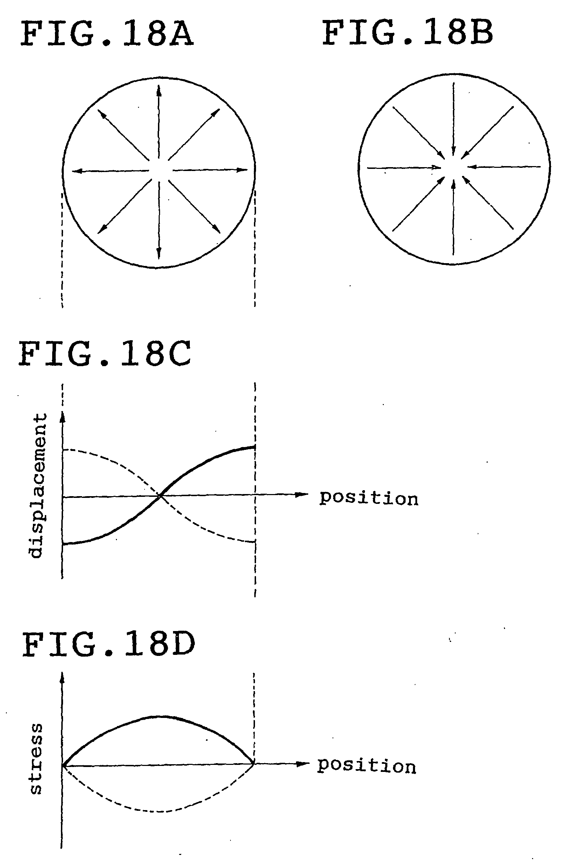

Hereinbelow, operational principles will be described. Description will be made referring to a case where the intermediate piezoelectric substrate 202 is set to an output section, and the piezoelectric substrates 201 and 203 provided on upper and lower portions thereof are respectively set to input sections. AC voltage waveforms having frequencies for causing primary order radially expanding vibrations are applied in the same phase to the disc substrate section formed on the almost entire face of the circular main faces of the piezoelectric substrate 201 and 203 of input section 201 and 203 so that the phases of the radially expanding vibrations of the two input substrates 201 and 203 match. According to electromechanical coupling, piezoelectric resonance having a vibrational node corresponding to the center of the main face is generated on each of the piezoelectric substrates 201 and 203. The states of the vibrations are illustrated in Figs.18A to 18D. The respective piezoelectric substrates repeat expansion and contraction according to basic radial vibrations as shown in Figs.18A and 18B. Figs.18C and 18D show a displacement distribution and a stress distribution, respectively, in the radially expanding direction of the basic radial vibration. As shown in Fig.18C, the loop portion where vibrations with a large displacement occur corresponds to the outer peripheral edge portion of the main face of the piezoelectric substrate, and the node portion where the displacement in the radial direction is smallest corresponds to the center of the main face of piezoelectric substrate. In this case, as shown in Figs.17A and 17B, when the piezoelectric substrates set to the input sections and the piezoelectric substrate set to the output section are connected together via the connector, vibrations of the input sections can be effectively transferred to the output section. In the output section, according to radial expansion electromechanical coupling, the mechanical vibration energy is converted to electrical vibrational energy, and the energy is output from the electrodes provided on the main faces of piezoelectric substrate 202. Air gaps are respectively formed in central portions in which the connectors do not exist and which greatly contributes for power generation. In this structure, vibrations in the thickness direction are not interfered.

To immobilize the above-described piezoelectric transformer, fixing fittings are connected to the central portions that correspond to the radially expanding vibrational nodes. Thereby, the piezoelectric transformer can be supported and immobilized without interference being caused for mechanical vibrations.

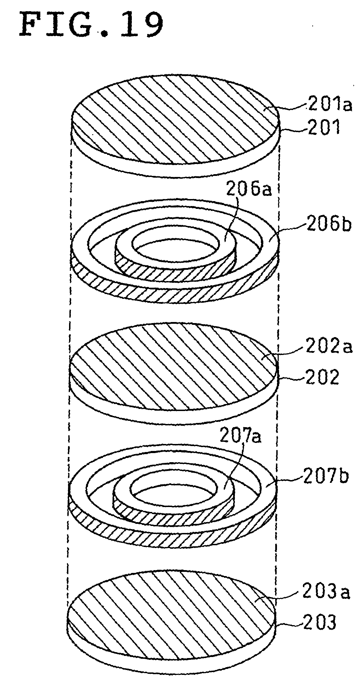

Hereinbelow, a description will be made regarding piezoelectric transformers using higher order radially expanding vibrations. Fig.19 is a vertically exploded view of a piezoelectric transformer using a third order mode of vibration. Piezoelectric substrates 201 and 202 are connected via two ring-like connectors 206a and 206b. Similarly, a reverse face of the piezoelectric substrate 202 and the piezoelectric substrate 203 are connected via the connectors 207a and 207b. Electrode pairs 201a, 201b, and 201c (the figure shows only one side faces) mutually opposing are formed on two circular main faces of the respective piezoelectric substrates. In a case where the piezoelectric substrates 201 and 203 are respectively set to input sections, and piezoelectric substrate 202 sandwiched therebetween is set to an output section, input AC voltage is applied between the respective electrode pairs of the piezoelectric substrates 201 and 203, and output voltage are taken out from the electrode pair of the piezoelectric substrate 202.

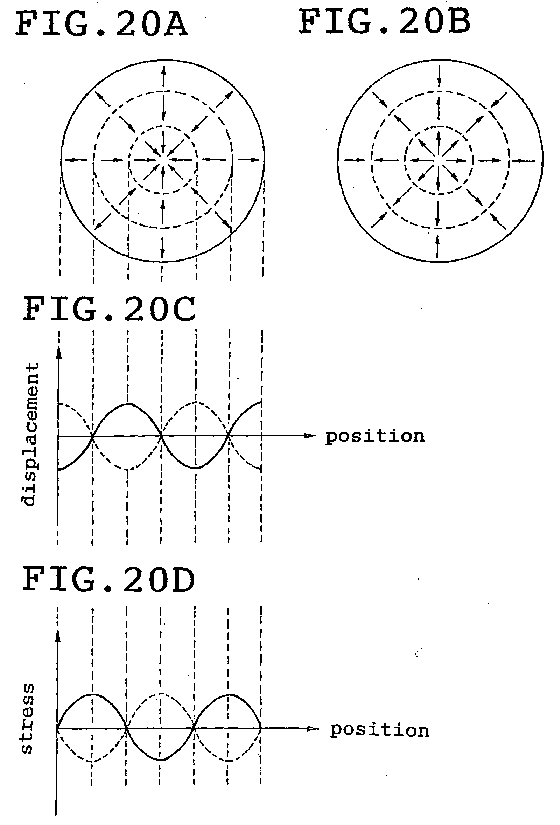

Figs.20A to 20D show states of a third-order-mode radially expanding vibrations. The piezoelectric substrate excited to vibrate in the aforementioned mode repeats expansion and contraction as shown in Figs.20A and 20B. Radial distributions in the displacement and stress in this case are shown in Figs.20C and 20D, wherein vibrational loop portions and node portions are formed. In the illustrated example, two connectors are positioned in two loop portions in the radial direction of the vibration, thereby enabling the vibration to be effectively transferred from the input section to the output section.

In this way, the number of the connectors is determined corresponding to the number of orders of the radially expanding vibrations, and the determined number of the connectors are provided in the loop portions that are determined according to the number of orders. Use of the high mode enables the driving frequency to be increased in the shape being maintained unchanged.

The ring-like connectors may be dimensioned so that they can be connected in the positions of the vibrational loop portions of the respective piezoelectric substrates. The positions of the vibrational loop portions of the piezoelectric substrate are determined according to factors, such as driving frequency, the dimensions of the piezoelectric substrate, and material property values of the piezoelectric material.

According to the disposition of each of the connectors in a ring or ring-like state, compared to a circular connector, interference is not caused for vibrations in the thickness direction in the center of the circle where the power generation efficiency is high. Thereby, a transformation ratio substantially as designed can be obtained. For the material of the connectors, either a conductive material or a dielectric material may be used. With a connector made of the dielectric material, the contacting area between the electrode and the connector disposed in a ring or ring-like state is small. In this case, since the inter input output capacitive coupling is reduced, a significant amount of noise propagating through capacitive coupling can be cut off.

In connection with the connectors respectively disposed in a ring or ring-like state, an additional advantage was found in that the element resonance frequency is reduced. The frequency is considered to decrease because the output section and the input section are added to each other as a mass that is added to the system of mechanical resonance, and the frequency of the system of mechanical resonance is thereby reduced. The resonance frequency can be adjusted in a range by changing the width of the ring or ring-like portion.

The respective piezoelectric substrates and connectors may be connected in a manner that each of the connectors is integrally sintered using a ceramic material.

In addition, in the structure shown in Figs.17A and 17B or Fig.9, although three piezoelectric substrates are connected via the connectors, the piezoelectric substrates and connectors may be increased in number in the thickness direction. In this case, the piezoelectric substrates forming the input sections and the output section are preferably disposed mirror symmetric with respect to a virtual symmetry plane positioned in the intermediate value in the thickness direction. Furthermore, according to the increase in the number of the piezoelectric substrates, a single input/multiple output transformer can be obtained.

### (Eleventh Embodiment)

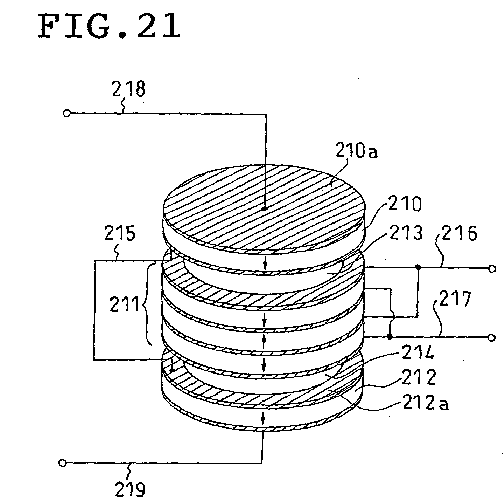

Fig.21 is a perspective view of a piezoelectric transformer according to the eleventh embodiment. The present embodiment will be described referring to a case where piezoelectric substrates 210 and 212 are respectively set to input sections, and a piezoelectric substrate 211 is set to an output section. Each of the piezoelectric substrates 210 and 212 is formed as a circular plate made of a PZT piezoelectric material, which is an ordinary piezoelectric transformer material, and disk electrodes 210a, 212a, and so forth are formed on the upper and lower surfaces of the piezoelectric substrates. The electrodes are formed such that Pd-Ag conductive paste is used, and electrode patterns are coated thereon according to a screen printing method and are sintered. The output section is formed of the piezoelectric substrate 211 that is made of the same piezoelectric material as the input section and that has a structure in which plural electrode layers and plural disk piezoelectric layers made of a piezoelectric material are alternately laminated in the thickness direction. Each of the piezoelectric substrates for the input sections is polarized so that the polarization axis extends perpendicular to the upper and lower surfaces. The piezoelectric substrate, which is the piezoelectric multilayer body for the output section, is polarized perpendicular to the upper and lower surfaces, and adjacent piezoelectric layers therein are polarized in mutually opposing parallel directions. In the multilayer structure fabricated as described above, the output impedance can be reduced, and the transformation ratio can be increased. In the structure, the output section is disposed between the two input sections; each of the ring-like connectors, which is formed of a PZT ceramic material between the piezoelectric substrate and the piezoelectric multilayer body, is disposed on the outer peripheral portion corresponding to the vibrational loop portion; and the respective contacting faces are bonded together with an adhesive such as a thermosetting epoxy adhesive or a polyimide adhesive. The piezoelectric transformer thus structured is 20 mm in diameter and 4 mm in width.

In the output section, the plural electrode layers are alternately electrically connected, and outputs are taken out through lead wires 216 and 217. In the input section, the electrodes formed on the mutually opposing faces of the two piezoelectric substrates 210 and 212 are connected through a lead wire 215, and alternating currents are applied on the electrodes on the outer end faces through lead wires 218 and 219 from power supplies. Thus, when the input substrates are series connected in capacity, the input impedance can be increase. When the two input substrates are parallel connected using a different connecting method, the input impedance can be reduced. The voltage step-up ratio is proportional to the square root of the ratio between the input impedance and the output impedance. When the substrates are electrically connected as shown in Fig.21, the input impedance is increased higher than the output impedance, thereby enabling voltage step-down operation to be performed. When the input and output connections are reversed, the input impedance is reduced lower than the output impedance, thereby enabling voltage step-up operation to be performed.

In addition, in the piezoelectric transformer of the present embodiment, the outside diameters of connectors 213 and 214 are smaller than the outside diameters of the piezoelectric substrates 210 and 212 and the outside diameter of the piezoelectric substrate 211, which is the piezoelectric multilayer body. Thereby, the peripheral end faces of the connectors are indented from the outer peripheries of the input and output substrates, thus forming stepped portions on the side faces. In this structure, per unit volume surface area is enlarged, thereby enabling heat radiation effects to be increased. Furthermore, since the electrodes are coated with resin, such as epoxy resin or polyimide resin, which has a high anti dielectric breakdown voltage property, the creeping distances between the input electrodes and the output electrode can be increased, and consequently, the anti dielectric breakdown voltage can be significantly increased.

For the material of the connectors, resin, such as epoxy resin or polyimide resin, which has high rigidity may be used. The plural piezoelectric substrates to be used as described above are set on molds of an injection molding machine, and in that state, the resin is subjected to injection molding. Thereby, the components for the transformer can be easily manufactured. In addition, since the insulation material is used for the connectors, the region between the input and the output can be insulated in terms of direct current.

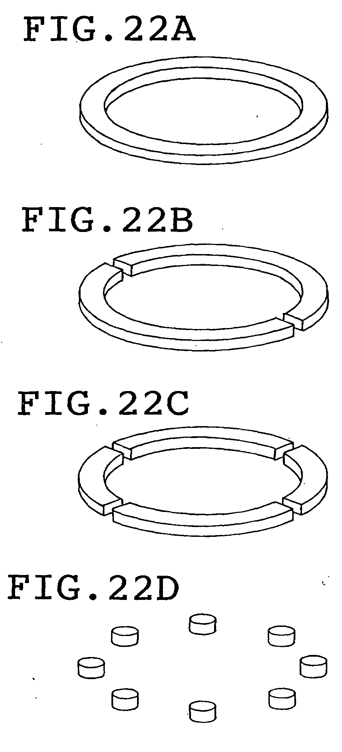

Example connector structures are shown in Figs.22A to 22D. In the present invention, the connector used between the piezoelectric substrates is not limited to be of a continuous ring as shown in Fig.22A. As shown in Fig.22B, 22C, or 22D, the connector may be of a discontinuous ring type, which is formed of segments disposed circular. The connector thus formed functions similar to the connector of the continuous ring type.

When the discontinuous ring type connector as shown in Fig.22B, 22C, or 22D, is used, the structure allows air to flow in an air gap surrounded by the connector. Thereby, the structure enables the prevention of, for example, an incident where the piezoelectric transformer generates heat that can cause rise in interior gas pressure, thereby peeling off adhesive layers and causing breakdown of the connector. In addition, when air flows from the outside into the air gap created by the connectors between the respective piezoelectric substrates, cooling effects increase in the internal air gaps, thereby enabling the maximum output power regulated by temperature rise to be increased.

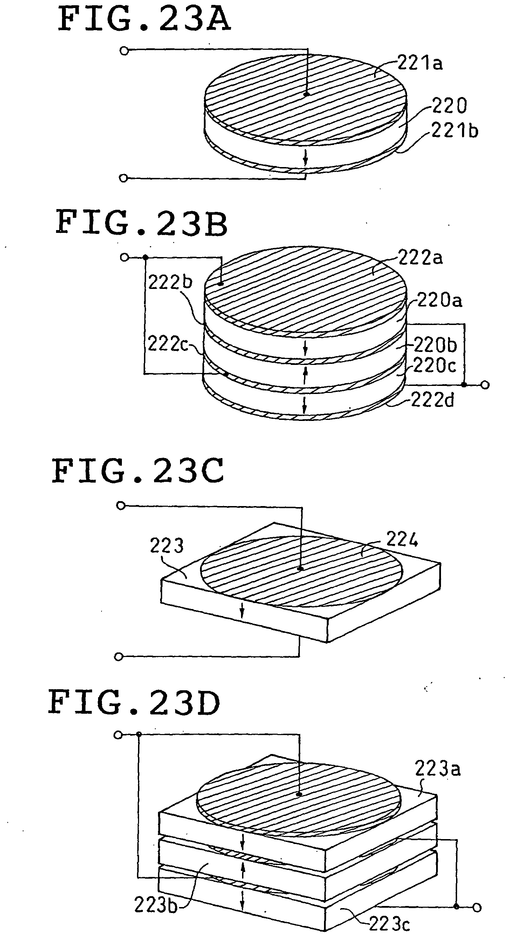

Figs.23A to 23D, 24A, 24B, 25A, 25B, 26A and 26B show various modified piezoelectric substrates usable to form the input substrate or output substrate according to the present embodiment. Each of the piezoelectric substrate as illustrated may be used for either the input section or the output section. Through combination of the illustrated piezoelectric substrates, a transformer having various input and output impedance ratios can easily be manufactured.

Fig.23A shows a piezoelectric substrate structured such that electrodes 221a and 221b are provided on two main faces of a disk piezoelectric substrate 220, the polarization is directed perpendicular to the electrode faces. Fig.23B shows a piezoelectric substrate characterized by having a structure wherein plural piezoelectric layers 220a, 220b, and 220c made of a piezoelectric material and the electrode layers 222a, 222b, 222c, and 222d are alternately laminated in the thickness direction. In the structure, the aforementioned plural electrodes are alternately electrically connected, and electrode layers mutually adjacent therein are insulated in terms of direct current. The polarization direction is perpendicular to the disk, and the polarization directions in piezoelectric layers mutually adjacent are mutually opposite in parallel. With the aforementioned piezoelectric multilayer body being used, the electrostatic capacity can be increased, thereby enabling impedance reduction to be implemented. Piezoelectric substrates shown in each of Figs.23C and 23D are structured through modification of the respective piezoelectric substrates in the disk shape shown in Figs.23A and 23B to be square. With the modification in the shape, when they are mounted as electronic components, dead space can be reduced. Thereby, the mounting space can be effectively used. In addition, the per unit volume heat radiation area is larger than in the case of the disk like piezoelectric substrate.

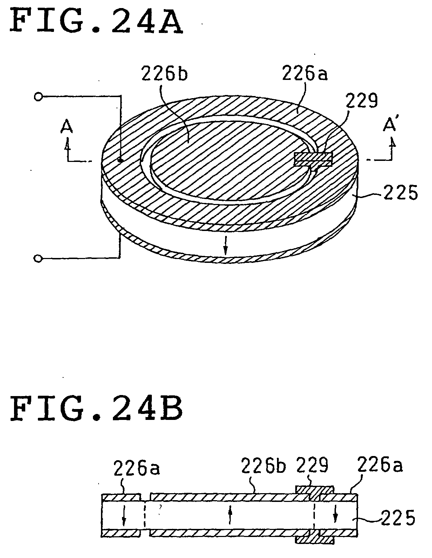

Fig.24A is a perspective view showing an example piezoelectric substrate having an electrode configuration that enables high order mode excitation, and Fig.24B is a cross sectional view thereof. A circular electrode 226b and an electrode 226a surrounding it are formed on each of upper and lower main faces of a piezoelectric substrate 225. The border between the two electrodes is positioned at an loop portion of a high order mode radially expanding vibration to thereby enable high order mode radially expanding vibrations to be generated. The polarization directions are mutually opposite in parallel in the thickness direction in a circular and cylindrical region between the two upper and lower ring-like electrodes 226b and in a circular and cylindrical region between the two upper and lower ring-like electrodes 226a. In addition, the electrodes positioned on the same main face are electrically connected through a conductor 229, thereby enabling the number of electrode external connection portions to be reduced.

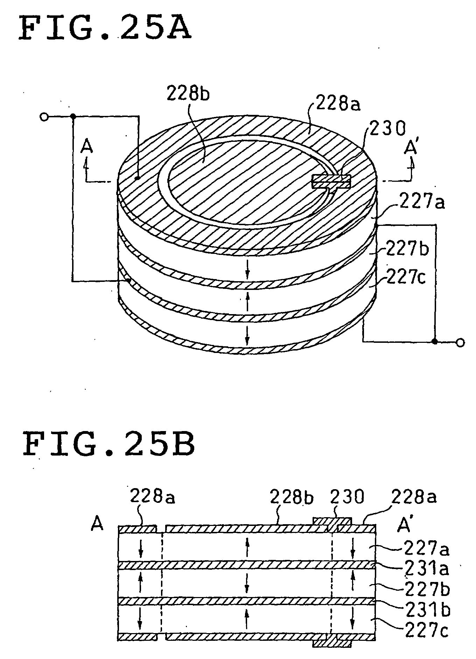

In a piezoelectric substrate formed of a piezoelectric multilayer body as shown in Figs.25A and 25B, instead of the piezoelectric body shown in Figs.24A and 24B, piezoelectric layers 227a, 227b, and 227c and electrode layers 231a and 231b are alternately laminated. In addition, a circular electrode 228b and an electrode 228a surrounding it are formed on each of upper and lower main faces of the piezoelectric multilayer body. In the fabrication of the above, as shown in Fig.25B, the polarization directions of regions adjacent to each other in the vertical and horizontal directions are set so as to be mutually opposite in parallel. Thereby, electrical connection can be carried out from the end face of the disks adhered to each other as described above. The piezoelectric multilayer body can also be fabricated through the adhesion of piezoelectric substrates 225 shown in Figs.24A and 24B.

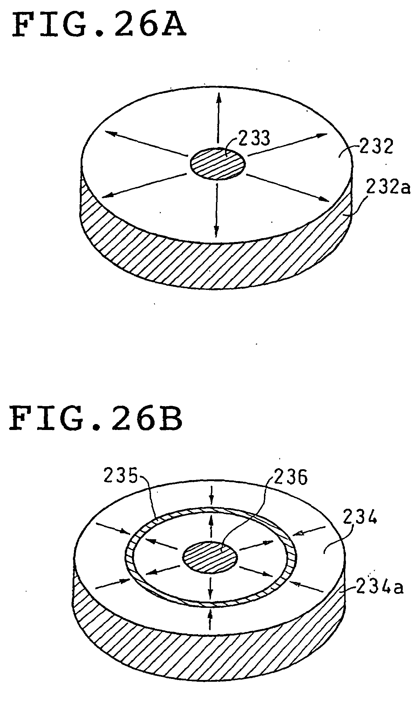

In each of piezoelectric substrates shown in Figs.26A and 26B, the polarization is established in the in plane direction, and concurrently in the radial direction from the center. In the piezoelectric substrate shown in Fig.26A, a circular electrode 233 in provided in a central portion of a piezoelectric substrate 232, and a ring-like electrode 232a is provided in an outer peripheral side portion. In the polarization direction, polarization axes radially extend in the region from the circular to the ring-like electrode. In this arrangement, the electrostatic capacity can significantly be reduced, and a substrate having a high impedance value can therefore be easily designed. The piezoelectric substrate shown in Fig.26B is made to operate even with high order mode radially expanding vibrations. In addition to a circular electrode 236 and a ring-like electrode 234a provided on a main face of a piezoelectric substrate 234, a second ring-like electrode 235 is provided in an loop portion of radially expanding vibration. The piezoelectric substrate is polarized in the in plane direction and concurrently in the radial direction from the center. The polarization direction between the center and the second ring-like electrode opposes the polarization direction between the second ring-like electrode and the ring-like electrode 234 in the outer peripheral portion. In each of the piezoelectric substrates shown in Figs.26A and 26B, the ring-like electrode 232a or 234a formed in the outer peripheral side portion may instead be formed on the main face of the piezoelectric substrate.

As described above, according to the tenth and eleventh embodiments, a piezoelectric transformer can be provided in which high efficiency, high electric power, and transformation ratios as designed can be obtained, and the resonance frequency can be reduced. Furthermore, with a dielectric being used for the connectors, electrostatic capacity between the input and the output is reduced, thereby enabling noise propagation to be cut off.

### (Twelfth and Thirteenth Embodiments)

Hereinbelow, twelfth and thirteenth the embodiments will be described.

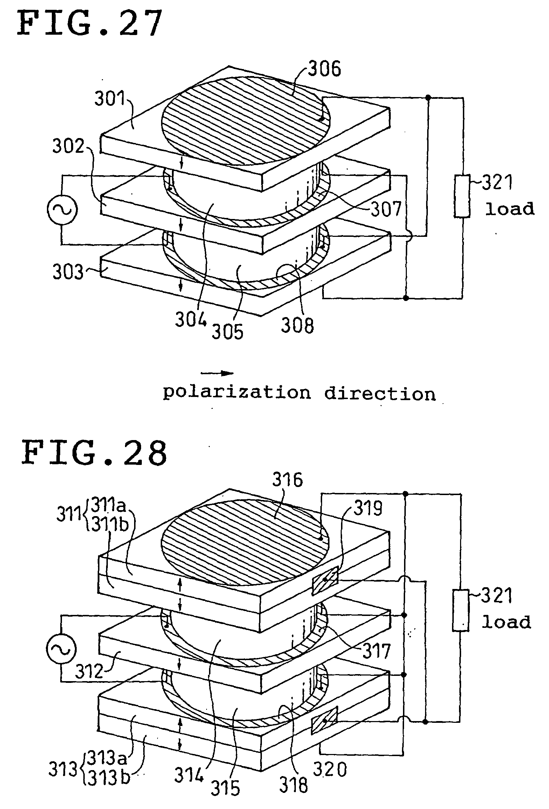

First, operational principles of the twelfth and thirteenth embodiments will be described with reference to Fig.27. Fig.27 is a schematic perspective view for explaining structures according to the twelfth and thirteenth embodiments. Circular electrode layers 306, 307, and 308 are formed on main faces of the respective plane-plate-like piezoelectric substrates 301, 302, and 303, which are formed of a piezoelectric ceramic material (electrodes on the reverse faces are not shown). The piezoelectric substrates 301, 302, and 303 are laminated with connectors 304 and 305 being sandwiched therebetween. The three piezoelectric substrates and the two connectors are integrated through adhesive layers formed on mutually contacting faces thereof.

Hereinbelow, operational principles will be described. Description will be made referring to a case where the intermediate piezoelectric substrate 302 is set to an input section, and the piezoelectric substrates 201 and 203 provided on outer portions thereof are respectively set to output sections. AC voltage waveforms having frequencies for causing primary order radially expanding vibrations are applied to the circular electrode layers provided on the obverse and reverse main faces of the piezoelectric substrate 302. According to a piezoelectric transverse effect, piezoelectric resonance having a vibrational node corresponding to the center of the plane plate is generated. In a manner similar to the above, piezoelectric resonance having a vibrational node corresponding to the center of the plane plate is generated in the piezoelectric substrate of the output section through the circular connector. The mechanical vibration energy is converted to electrical vibrational energy according to a piezoelectric transverse effect, and the energy is output.

The transformation ratio is proportional to the square root of the ratio between the input impedance and the output impedance. In the present embodiment, since the input impedance is higher than the output impedance, operation as a voltage step down transformer can be performed.

The present invention as described above enables inter input output electrical insulation. In specific, when the structure is used, since the connectors made of the insulating material is inserted between the inputs and the output, the inter input output electrical insulation is enabled. Furthermore, since the surface area is large, the heat radiation effects are increased, and high electric power can thereby be output.

### (Twelfth Embodiment)

Hereinbelow, referring to Fig.27, a piezoelectric transformer according to the present embodiment will be described. In the piezoelectric transformer of the present embodiment, an input section is formed of a square plane plate made of a PZT piezoelectric material, which is an ordinary piezoelectric transformer material. On upper and lower faces of the square plane plate, there are formed circular electrodes such as to be inscribed on peripheral sides of the square plane plate by using a Pd-Ag conductive paste according to a screen printing method. An output section is formed of the same piezoelectric material as for the input section, and the electrodes also are formed similar to those of the input section. Polarization processing is performed for the respective plane plates so that polarization axes therein are directed perpendicular to the plane plates. The input section is disposed between the two output sections, disk-like connectors made of a PZT ceramic material are disposed between the plane plates. Mutually contacting faces of the plane plates and the connectors are bonded using a thermosetting epoxy adhesive. In this way, the piezoelectric transformer is structured. With the aforementioned insulating materials being inserted, inter input output electrical insulation is enabled. The piezoelectric transformer has a size of 24 mm × 24 mm × 4 mm. The voltage step-up ratio is proportional to the square root of the ratio between the input impedance and the output impedance. In the embodiment shown in Fig.27, input voltages are applied to obverse and reverse electrode layers of the piezoelectric substrate 302; and in the output side, the electrode layer 306 on the obverse side of the outer piezoelectric substrate 301 is electrically connected to the electrode 308 on the obverse side of the piezoelectric substrate, reverse face electrode layers (not shown) are thereby electrically connected together, and they are connected to a load 321. Thereby, voltage step-down operation can be performed. When the connections of the input and the outputs are reversed, voltage step-up operation can be performed. For the inter electrode layer connections, the electrode layers having the same polarity of the piezoelectric substrate polarization may be electrically connected together.

### (Thirteenth Embodiment)

Fig.28 is a perspective view of a structure wherein output sections of a piezoelectric transformer according to the present embodiment are laminated. The present embodiment is the same as the embodiment 12 except for the configuration of the output sections. The output sections of the piezoelectric transformer according to the present embodiment are formed of laminated piezoelectric substrates 311 and 313. The respective piezoelectric substrates are formed of square piezoelectric plates 311a, 311b, 313a and 313b made of a PZT piezoelectric material, which is an ordinary piezoelectric transformer material. On the obverse and reverse faces of the piezoelectric plate and between the piezoelectric plates, disc electrode layers 316, 317, and 318 are formed such as to respectively be inscribed on peripheral sides of the square plane plates (electrode layers on the reverse faces and inner electrodes are not shown). These electrode layers are formed by using a Pd-Ag conductive paste according to a screen printing method. On end faces of the piezoelectric substrates 311 and 313, connection terminals 319 and 320 of the inner electrodes are formed. The polarization directions of the piezoelectric plates of the output sections are perpendicular to the main faces of the piezoelectric plates, and the polarization directions of the piezoelectric plates adjacent to each other are mutually opposite in parallel.

In the piezoelectric transformer of the present embodiment, in the electrodes provided on the piezoelectric substrate 311, a group in which two electrode layers alternately formed on the obverse and reverse main faces of the piezoelectric substrate 311 is used as a first electrode group. An inner electrode provided between piezoelectric plate 311a and 311b while it is only one electrode layer is used as a second electrode group. The respective first electrode group and the second electrode group are used as the output sections. The arrangement similar to the above is made for the piezoelectric substrate 313. The first electrode groups of the upper and lower piezoelectric substrates 311 and 313 are electrically connected together, and are used as one of the output electrodes. Similarly, the second electrode groups are electrically connected together, and are used as the other one of the output electrodes. The output electrodes thus arranged are then connected to a load 321.

In the present embodiment, since the piezoelectric substrates 311 and 333 are connected to be a multilayer structure, the impedance thereof is reduced. In this case, the voltage step-up ratio and the voltage step-down ratio can be increased.

As described above, according to the above-described twelfth and thirteenth embodiments, high electric power can be output, and inter input output electrical insulation can be established.

In each of the piezoelectric transformers according to the present invention, to prevent electric discharge to the interelectrode portion of the output electrode and the adjacent input section, a high voltage resisting resin film, such as polyimide resin film, may be inserted in the inter input output air gap. Alternatively, vanish made of a silicon adhesive, an epoxy adhesive, or polyimide resin may be applied therein.

In each of the above embodiments, description has been made regarding the case where the piezoelectric substrates and the connectors are connected using adhesives. However, the connections can be obtained in a way in which ceramic materials are used for forming the piezoelectric substrates and the connectors, and the connectors and the piezoelectric substrates are integrally sintered in the step of sintering of the piezoelectric substrate. In this case, the connectors are preferably polarized perpendicular to the main faces of the piezoelectric substrate. Alternatively, the connectors may be formed of an adhesive having a high rigidity.

### INDUSTRIAL APPLICABILITY

As described above, according to the present invention, a piezoelectric transformer generating higher output can be obtained.

As a result, the present invention can preferably be utilized especially for a piezoelectric transformer used in a power converter, such as an inverter for a backlight of a liquid display and a DC-DC converter.

## Claims

1. A piezoelectric transformer, **characterized in that** at least two piezoelectric substrates are connected via at least two connectors, each of said at least two piezoelectric substrates being formed of a piezoelectric material, having a plane plate shape and including a first main face and a second main face opposing thereto, wherein
said at least two piezoelectric substrates include a first piezoelectric substrate and a second piezoelectric substrate;
said first main face of one of said first piezoelectric substrate and said second piezoelectric substrate is disposed opposite to said second main face of the other one of said first piezoelectric substrate and said second piezoelectric substrate;
said at least two connectors and an air gap are provided between said first main face of said one of the piezoelectric substrates and said second main face of said other of the piezoelectric substrates; and
an input section is provided at said one of the piezoelectric substrates, and an output section is provided at said other of the piezoelectric substrates.

2. A piezoelectric transformer as recited in claim 1, **characterized in that**
said at least two connectors include a first connector, a second connector, and a third connector;
said air gap is provided between said first connector, said second connector, and said third connector;
each of said first piezoelectric substrate and said second piezoelectric substrate has a rectangular parallelepiped shape, and is divided into N equal regions (N is an integer which is equal to two or larger) in a longitudinal direction;
said first connector and said second connector are positioned at longitudinal end portions of said piezoelectric substrates; and
said third connector is positioned at a border of said regions of each of said first piezoelectric substrate and said second piezoelectric substrate.

3. A piezoelectric transformer as recited in claim 1 or 2, **characterized in that**
electrodes are respectively provided on said first main face and said second main face of said first piezoelectric substrate, and said first piezoelectric substrate between said electrodes is polarized in a direction perpendicular to said first main face.

4. A piezoelectric transformer as recited in claim 1 or 2, **characterized in that**
said first piezoelectric substrate have a structure in which a plurality of electrode layers and a plurality of piezoelectric material layers each formed of a piezoelectric material are alternately laminated, said plurality of electrode layers are grouped into two electrode groups, and said electrode layers within the same electrode group are electrically connected to each other.

5. A piezoelectric transformer as recited in claim 2, **characterized in that**
electrodes are respectively provided at both ends in said longitudinal direction and at the border between said regions of at least one of said first piezoelectric substrate and said second piezoelectric substrate, said piezoelectric substrate between said electrodes is polarized parallel to said longitudinal direction, and polarization directions of said regions adjacent to each other are mutually opposite in parallel.

6. A piezoelectric transformer as recited in claim 2,
**characterized in that**
each of said regions of said first piezoelectric substrate or said second piezoelectric substrate has a structure in which a plurality of electrode layers and a plurality of piezoelectric material layers formed of a piezoelectric material are alternately laminated in a thickness direction of said first piezoelectric substrate or said second piezoelectric substrate,
said piezoelectric material layer between said electrodes in each of said regions is polarized parallel to said thickness direction,
polarization directions of said piezoelectric material layers adjacent to each other in said thickness direction are mutually opposite in parallel,
said plurality of electrode layers in said each region are grouped into two electrode groups, and said electrode layers within the same electrode group are electrically connected to each other.

7. A piezoelectric transformer as recited in claim 2, **characterized in that**
each of said regions of said first piezoelectric substrate or said second piezoelectric substrate has a structure in which a plurality of electrode layers and a plurality of piezoelectric material layers formed of a piezoelectric material are alternately laminated in said longitudinal direction,
said piezoelectric layer between said electrodes in each of said regions is polarized parallel to said longitudinal direction,
said plurality of electrode layers in said each region are grouped into two electrode groups, and said electrode layers within the same electrode group are electrically connected to each other.

8. A piezoelectric transformer as recited in any one of claims 1 to 7, **characterized in that**
an electrical connection portion, which is to be connected to an external circuit, of said input section is formed on a side face along said longitudinal direction and at a vibrational node portion in said longitudinal direction of said one of said piezoelectric substrates;
an electrical connection portion, which is to be connected to the external circuit, of said output section is formed on a side face along said longitudinal direction and at a vibrational node portion in said longitudinal direction of said other of said piezoelectric substrates; and
an electrical connection between said electrical connection portion, which is to be connected to the outside, of said input section and said external circuit and an electrical connection between said electrical connection portion, which is to be connected to the outside, of said output section and said external circuit, and mechanical connections to support the piezoelectric transformer are performed via conductors.

9. A piezoelectric transformer, **characterized by** comprising:
at least two piezoelectric substrates respectively including two main faces opposite to each other, said at least two piezoelectric substrates including a first piezoelectric substrate and a second piezoelectric substrate, and
a connector either formed or disposed as a ring in which an air gap is provided, wherein
said first piezoelectric substrate and said second piezoelectric substrate are disposed such that said main faces of said first and second piezoelectric substrates are opposed to each other, and said first and second piezoelectric substrates are connected together between said main faces via said connector; and
an input section is provided in said first piezoelectric substrate, and an output section being provided in said other of said piezoelectric substrates.

10. A piezoelectric transformer as recited in claim 9, **characterized in that** said connector provided between said first piezoelectric substrate and said second piezoelectric substrate is positioned at a vibrational loop portion of a radially-expanding vibration of said first piezoelectric substrate and said second piezoelectric substrate.

11. A piezoelectric transformer as recited in claim 9 or 10, **characterized in that**
an electrode is provided on each of said two main faces of each of said first piezoelectric substrate and said second piezoelectric substrate, and said first piezoelectric substrate and said second piezoelectric substrate are respectively polarized in a direction perpendicular to said main faces.

12. A piezoelectric transformer as recited in claim 9 or 10, **characterized in that**
a circular electrode is provided at a central portion of at least one of said main faces of at least one of said first piezoelectric substrate and said second piezoelectric substrate,
a ring-like electrode is provided at an outer edge portion of said at least one of said main faces of said at least one of said first and second piezoelectric substrates, and said at least one of said first piezoelectric substrate and said second piezoelectric substrate between said circular electrode and said ring-like electrode is polarized in a radial direction.

13. A piezoelectric transformer as recited in claim 9 or 10, **characterized in that**
at least one of said first piezoelectric substrate and said second piezoelectric substrate has a structure in which a plurality of electrode layers and a plurality of piezoelectric material layers formed of a piezoelectric material are alternately laminated in a thickness direction, said plurality of electrode layers are alternately electrically connected, and the electrode layers adjacent to each other are insulated in terms of direct current.

14. A piezoelectric transformer, **characterized in that**
at least two piezoelectric substrates having a plane plate shape and made of a piezoelectric material are connected via at least one connector having a disk shape and made of an insulating material,
said at least two piezoelectric substrates include a first piezoelectric substrate and a second piezoelectric substrate,
said first piezoelectric substrate and said second piezoelectric substrate are connected via said connector of said at least one connector; and
an input section is provided in one of said first piezoelectric substrate and the aforementioned second piezoelectric substrate, an output section being provided in the other of said first and second piezoelectric substrates.

15. A piezoelectric transformer as recited in claim 14, **characterized in that**
said first piezoelectric substrate and said second piezoelectric substrate respectively include a first main face and a second main face,
an electrode layer is provided on each of said first main face and said second main face of each of said first piezoelectric substrate and said second piezoelectric substrate, and
said first piezoelectric substrate and said second piezoelectric substrate between said electrode layers are respectively polarized in a direction perpendicular to said first main faces.

16. A piezoelectric transformer as recited in claim 14, **characterized in that**
at least one of said first piezoelectric substrate and said second piezoelectric substrate has a structure in which a plurality of electrode layers and a plurality of piezoelectric layers formed of a piezoelectric material are alternately laminated in a thickness direction, and said plurality of electrode layers are grouped into two electrode groups in which said electrode layers are alternately electrically connected.

17. A piezoelectric transformer as recited in claim 15 or 16, **characterized in that**
said electrode layers provided on said first piezoelectric substrate and said second piezoelectric substrate have circular shapes.

18. A piezoelectric transformer as recited in any one of claims 14 to 17, **characterized in that**
said first main faces and said second main faces of said first piezoelectric substrate and said second piezoelectric substrate have square shapes and a center of a circle drawn to be inscribed in said square coincides with a center of said connector provided between said first piezoelectric substrate and said second piezoelectric substrate.

19. A piezoelectric transformer as recited in any one of claims 14 to 16, **characterized in that**
sizes of main faces of said connector, which are opposed to said main faces of said first piezoelectric substrate and said second piezoelectric substrate, are equal to or smaller than circles drawn to be inscribed in peripheries of said main faces of said first piezoelectric substrate and said second piezoelectric substrate.

20. A piezoelectric transformer as recited in claim 1, 2, 9 or 14, **characterized in that**
said at least two piezoelectric substrates further include a third piezoelectric substrate,
said third piezoelectric substrate is set to be either the input section or the output section, and
said first to third piezoelectric substrates are disposed so that the input section and the output section are disposed mirror symmetric.
